# EUROPEAN PATENT SPECIFICATION

(11) **EP 2 740 183 B1**
(45) Date of publication and mention of the grant of the patent: **06.02.2019**
(21) Application number: 12820565.5
(22) Date of filing: 16.07.2012
(51) Int. Cl.: H01R 13/66, H02G 3/14

(54) **ACTIVE COVER PLATES**
AKTIVE ABDECKPLATTEN
PLAQUE DE REVÊTEMENT ACTIVE

(30) Priority: 01.08.2011 US 201161574344 P; 02.05.2012 US 201213461915
(43) Date of publication of application: 11.06.2014
(73) Proprietor: Snaprays, LLC, Vineyard, UT 84057 (US)
(72) Inventor: SMITH, Jeremy, Orem, Utah 84057 (US)
(74) Representative: Schwan Schorer & Partner mbB
(86) International application number: PCT/US2012/046946
(87) International publication number: WO 2013/019394

(56) References cited:
- CN-Y- 201 311 835
- US-A- 2 045 199
- US-A- 2 227 549
- US-A- 2 575 820
- US-A- 4 617 613
- US-A- 4 617 613
- US-A- 5 016 398
- US-A- 6 087 588
- US-A- 6 087 588
- US-A1- 2005 264 383
- US-A1- 2009 153 438
- US-B1- 6 395 981
- US-B1- 6 423 900
- US-B1- 6 423 900
- US-B1- 7 821 160

## Description

### BACKGROUND

Devices intended for prolonged use in electrical outlets are quite common. For example, many people have nightlights that are plugged into a particular outlet and remain there. These nightlights provide a low light level in a particular area in order to provide visibility either at night or in when ambient conditions do not provide adequate lighting.

However, nightlights suffer from a number of drawbacks. For example, they require an outlet in the area (i.e. a nightlight cannot be placed, higher or lower than an electrical outlet, near an electrical switch, or in many other areas that a user may desire its installation). Thus, in numerous locations, either brighter light must be used or a nightlight will not be possible for installation (i.e., only areas with available outlets are able to provide lighting, irrespective of user preferences and needs).

In addition, the installation of a nightlight blocks one or both outlets available at a receptacle. Once the nightlight is plugged into an outlet, that space becomes unavailable for other devices. If the user wishes to use the outlet, he/she must unplug the nightlight to free the outlet, which forces the user to select one or the other for use. Some nightlights have a built in outlet allowing other devices to be plugged into the nightlight, and thus receive power from the outlet. However, the nightlight may require a certain level of power that limits the functionality of other devices.

Of necessity, nightlights protrude from the outlet. This may result in the nightlight being bumped or otherwise displaced and can cause harm to the person bumping into the nightlight or to the nightlight itself. In addition, it may partially unplug the nightlight, creating an electrocution or fire hazard.

Direct wiring to the nightlight is possible. For example, the nightlight can be wired directly to electrical power without using a plug. However, this makes installation and replacement time consuming and dangerous. For example, if the wiring is not done correctly there can be a danger of electrocution or a fire hazard.

Accordingly, there is a need in the art for an active cover plate that does not protrude from an outlet. In addition, there is a need in the art for the cover plate to be easily installed or replaced. Further, there is a need in the art for the cover plate to be available for installation at other receptacle types, such as switches. There is a need in the art for the cover plate to leave outlets free for other uses and there is a need in the art for the cover plate to install safely, in accordance with all electrical codes.
US 6,087,588 relates to an active cover plate system according to the preamble of claim 1, wherein the power extractor comprises spring-strips, US7821160 relates to a modular wall box system. The power to a separate user interface is transmitted through inductive coupling, with communication between the load and the separate user interface through wireless means.

The invention relates to an active cover plate system as defined in claim 1.

### BRIEF DESCRIPTION OF THE DRAWINGS

The accompanying drawings illustrate various examples of the principles described herein and are a part of the specification. The illustrated examples are merely examples and do not limit the scope of the claims.
Figure 1A is a front view of an illustrative active cover plate, according to one example of principles described herein.
Figure IB is a rear perspective view of an illustrative active cover plate, according to one example of principles described herein.
Figure 1C is a top view of an illustrative active cover plate, according to one example of principles described herein.
Figure 2 is an example of an illustrative outlet, according to one example of principles described herein.
Figure 3A is a rear view of an illustrative active cover plate in combination with the outlet, according to one example of principles described herein.
Figure 3B is a front view of an illustrative active cover plate in combination with the outlet, according to one example of principles described herein.
Figure 4A is a front view of an illustrative active cover plate for use with a switch, according to one example of principles described herein.
Figure 4B is a rear perspective view of the illustrative active cover plate of Figure 4A, according to one example of principles described herein.
Figure 5 is a front view of an illustrative switch, according to one example of principles described herein.
Figure 6 is a perspective view of an illustrative active cover plate for a three way switch, according to one example of principles described herein.
Figure 7 is a front view of a 3-way switch, according to one example of principles described herein.
Figure 8 is a front view of an illustrative active cover plate, according to one example of principles described herein.
Figures 9A-E are diagrams of illustrative cover plates with power extractors that include insulated resilient conductors, according to one example of principles described herein.
Figure 10A is a schematic diagram of an illustrative inductive coil power extractor for an active cover plate, according to one example of principles described herein.
Figure 10B is a perspective view of an active cover plate that includes an inductive coil system, according to one example of principles described herein.
Figure 11A is a front view of an illustrative coil clip, according to one example of principles described herein.
Figure 11B is a front view of a coil clip in place around an outlet, according to one example of principles described herein.
Fig. 11C is a back view of an outlet with a coil clip and an active cover plate inductively interfacing with the coil clip to extract energy from the outlet, according to one example of principles described herein.
Figure 12A is a front view of an illustrative stab-in clip, according to one example of principles described herein.
Figure 12B a rear perspective view of the stab-in clip connected to an outlet, according to one example of principles described herein.
Figure 12C is a back view of an outlet with a connected stab-in clip and an active cover plate inductively interfacing with the stab-in clip to extract energy from the outlet, according to one example of principles described herein.
Figure 13A is a perspective view of outlet with internal high voltage coils, according to one example of principles described herein.
Figure 13B is a rear view of an active cover plate inductively interfacing with the internal coils in an outlet, according to one example of principles described herein.
Figures 14A and 14B show a Europlug outlet with an integral coil that powers an active cover plate, according to one example of principles described herein.
Figure 14C is a diagram of a two gang switch with an integral coil that powers an active cover plate, according to one example of principles described herein.
Figure 15A is an active cover plate with touch sensitive control areas, according to one example of principles described herein.
Figure 15B is an active cover plate with a touch sensitive control area, according to one example of principles described herein.
Figure 16A shows an illustrative active cover plate that is fitted with four insulated power extractors, according to one example of principles described herein.
Figure 16B is a rear view of the active cover plate of Figure 16A that has been properly attached to an electrical receptacle, according to one example of principles described herein.
Figure 17A is a plan view of an illustrative adjustable slider for an active cover plate, according to one embodiment of principles described herein.
Figures 17B and 17C are diagrams illustrating the functionality of an adjustable slider, according to one example of principles described herein.
Figure 18A is an angled rear view of a two-switch active cover plate with three cover blade tabs, according to one example of principles described herein.
Figure 18B shows an active cover plate with three cover blade tabs being installed to two-switch outlet box, according to one example of principles described herein.

Throughout the drawings, identical reference numbers designate similar, but not necessarily identical, elements.

### DETAILED DESCRIPTION

Reference will now be made to the figures wherein like structures will be provided with like reference designations. In the following description, for purposes of explanation, numerous specific details are set forth in order to provide a thorough understanding of the present systems and methods. It will be apparent, however, to one skilled in the art that the present apparatus, systems and methods may be practiced without these specific details. It is understood that the figures are diagrammatic and schematic representations of some embodiments of the invention, and are not limiting of the present invention, nor are they necessarily drawn to scale. Reference in the specification to "an example" or similar language means that a particular feature, structure, or characteristic described in connection with the example is included in at least that one example, but not necessarily in other examples.

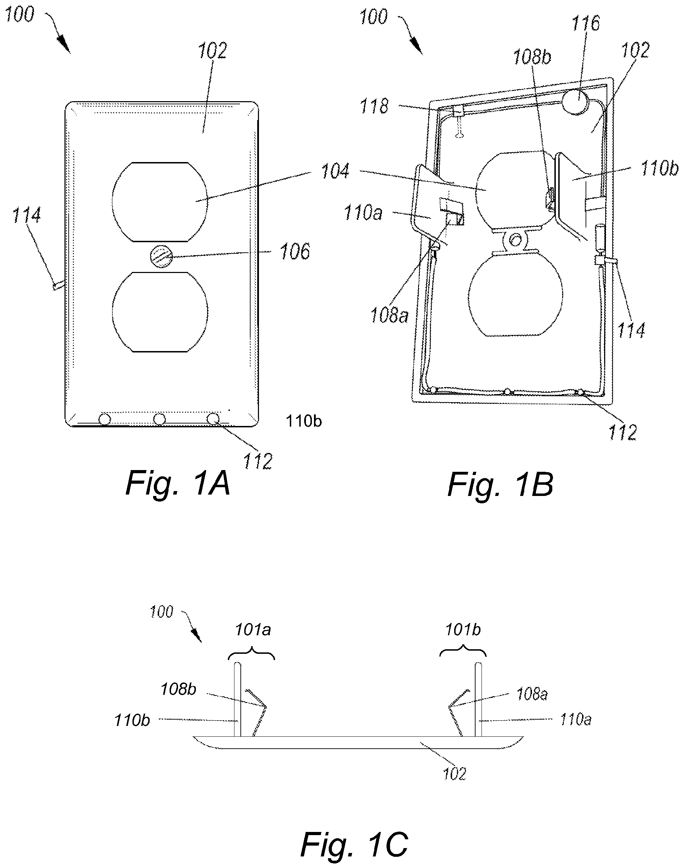

Figures 1A, 1B and 1C illustrate one example of an active cover plate (100). Figure 1A illustrates a front view of the active cover plate (100); Figure 1B illustrates a rear perspective view of the active cover plate (100); and Figure 1C illustrates a top view of the cover plate (100). In at least one implementation, the cover plate (100) is configured to be placed over an outlet. When secured in place over the outlet, the cover plate (100) prevents access to an electrical box containing electrical wiring and connections to the outlet.

Figures 1A, 1B and 1C show that the active cover plate (100) can include a faceplate (102). In this example, the faceplate (102) is shaped to mate with the outlet to prevent access to the electrical box in which the outlet is mounted while allowing electrical devices to make connections to the outlet through apertures (104). The faceplate (102) can include an insulating material to accidental electrical contact with energized elements within the electrical box. For example, the faceplate (102) can include plastic. The faceplate (102) can be a single color or can include designs as desired.

Figures 1A, 1B and 1C further show that the cover plate (100) can include an attachment (106). In at least one implementation, the attachment (106) can include a screw hole or attached screw. The screw can be inserted into a threaded hole and tightened to hold the cover plate (100) in place relative to the outlet. A variety of other attachment methods can be used. For example, the active cover plate may include magnetic fasteners, mechanical clips, alignment pins, or other mechanisms which work alone or in combination with other fasteners. In one implementation, the attachment (106) can include one or more tabs that are attached to the outlet or electrical box. The tabs may be inserted into a hole and are retained by a flange or other mechanism within the outlet or electrical box.

Figures 1A, 1B and 1C additionally show that the cover plate (100) can include a first resilient conductor (108a) and a second resilient conductor (108b) (collectively "resilient conductors 108"). In at least one implementation, the resilient conductors (108) can allow the cover plate to draw power from electricity supplied to the outlet. The resilient conductors (108) come in contact with the power connectors of the outlet, drawing power as needed, as described below.

Figures 1A, 1B and 1C also show that the cover plate (100) can include a first insulating tab (110a) and a second insulating tab (110b) (collectively "insulating tabs 110"). In this example, the power extractors (101) of the active cover plate include the insulating tabs (110) and the resilient conductors (108). In at least one implementation, the insulating tabs (110) can prevent the resilient conductors (108) from forming a circuit with external materials. As the resilient conductors (108) come in contact with the power terminals on the outlet, the resilient conductors may bend outward. This flexibility insures that the resilient conductors (108) remain in contact with the power connectors. However, it can also force the resilient conductors (108) toward wires, the electrical box or other materials in the area. The insulating tabs (110) prevent the resilient conductors from contacting the wires, electrical box or other materials. In addition, the insulating tabs (110) may prevent arcing between the resilient conductors (108) and external conductors.

The insulating tabs (110) can be the same material as the faceplate (102) or can be attached to the faceplate (102). For example, the faceplate (102) and the insulating tabs (110) can be constructed of a single piece of insulating material. In one example, the insulating tabs (110) are integral features of the face plate (102). In this case the insulating tabs (110) can be formed during injection molding of the face plate (102). Additionally or alternatively, the insulating tabs (110) can be manufactured separately and then attached to the faceplate (102). In one example, a rear plate is separately formed that includes the insulating tabs and is designed to cover electrical components in the active face plate. After the electronic components and circuits are formed and connected to the face plate, the rear plate can be fasted over the circuits. The attachment method retains the insulating capabilities of the insulating tabs (110). For example, the insulating tabs (110) and/or rear plate can be attached to the faceplate (102) using an insulating glue.

Figures 1A, 1B and 1C further show that the cover plate (100) can include a load (112). In at least one implementation, the load (112) can include any electrical device that requires power. For example, the load (112) can include an electrical device embedded within the cover plate (100). For example, the load (112) can include lights, motion detectors, photocells, wireless nodes, blue tooth connectors, smoke detectors, carbon monoxide detectors, cameras, heat detectors, speakers, microphones or any other desired electrical device.

Figures 1A, 1B and 1C show an illustrative load (112) which includes a bank of light emitting diodes. A light-emitting diode (LED) is a semiconductor light source. LEDs can produce high intensity light with less power than conventional light sources. In particular, LEDs convert a higher percentage of input power to light and a lower percentage to heat or other waste.

Figures 1A, 1B and 1C additionally show that the cover plate (100) can include a power switch (114). In at least one implementation, the power switch (114) can allow a user to turn on or off or dim the load (112). For example, if the load (100) is a light, the power switch (114) can allow the user to select the brightness of the light or to turn off the light such that it does not produce light.

Figures 1A, 1B and 1C also show that the cover plate (100) can include a battery backup (116). In at least one implementation, the battery backup (116) can ensure that the load (112) continues to receive power for a time, even if power from the power source is discontinued. For example, the battery backup (116) can be charged by the power source when the power source is active. When the power source is inactive, the battery backup (116) can supply power to the load (112). The battery backup can be configured to provide power to the load (112) but not the power source so that when the power source is inactive it does not act as an additional load on the battery backup (116).

Figures 1A, 1B and 1C further show that the cover plate (100) can include a network device (118). In at least one implementation, the network device (118) can allow the cover plate (100) to connect to a network. For example, the network device (118) can include an antenna. Additionally or alternatively, the network device (118) can include an Ethernet port or any other connection capable of connecting the cover plate (100) to a desired network.

In at least one implementation, the network can be used to connect multiple cover plates (100) to one another. Additionally or alternatively, the network can allow the cover plate to communicate with a controller or over the Web. The network exemplarily includes the Internet, including a global internetwork formed by logical and physical connections between multiple wide area networks and/or local area networks and can optionally include the World Wide Web ("Web"), including a system of interlinked hypertext documents accessed via the Internet. Alternately or additionally, the network includes one or more cellular RF networks and/or one or more wired and/or wireless networks such as, but not limited to, 802.xx networks, Bluetooth access points, wireless access points, IP-based networks, or the like. For example, the network can include cloud based networking and computing. The network can also include servers that enable one type of network to interface with another type of network.

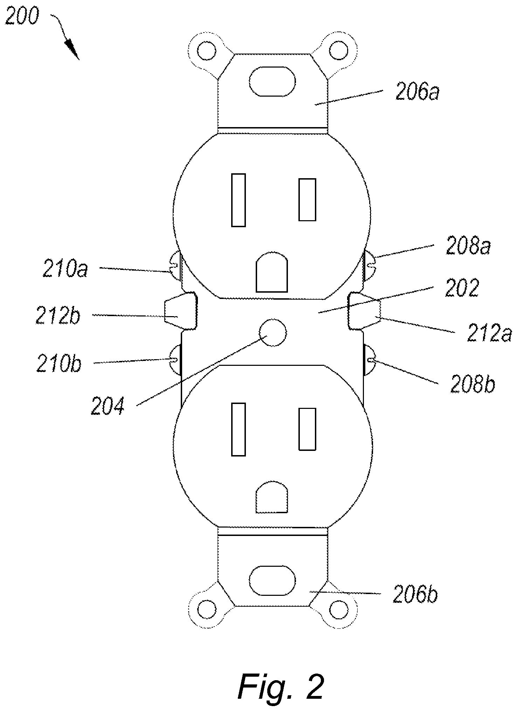

Figure 2 illustrates an example of an outlet (200). In at least one implementation, the outlet (200) can provide power to an external device. I.e., the outlet (200) is configured to receive a plug of an external device and provide power to the plug. The outlet (200) can be direct wired to an electrical power source. For example, the outlet (200) can be placed within a home or business, with wiring from the building power supply.

Figure 2 shows that the outlet (200) can include a body (202). In at least one implementation, the body (202) is configured to receive a plug from an external device. For example, the body (202) includes sockets that allow the conducting leads of a plug to be inserted and make contact, which allows current flow to the plug but prevents current flow to anything other than the plug. The body (202) can include multiple sockets, each of which is configured to receive a plug.

Figure 2 also shows that the outlet (200) can include a bore (204). In at least one implementation, the bore (204) is configured to receive the attachment of a cover plate. In particular, the bore (204) can allow the attachment of the cover plate to secure the cover plate relative to the outlet (200). For example, the bore (200) can include a threaded opening for receiving a screw or any other device for the cover plate attachment. The cover plate can be configured to mate with the body (202) in order to maintain the proper orientation, such that a single bore (204) can retain the cover plate.

Figure 2 further shows that the outlet (200) can include a first mounting piece (206a) and a second mounting piece (206b) (collectively "mounting pieces 206"). In at least one implementation, the mounting pieces (206) are configured to attach the outlet (200) to an electrical box. For example, the mounting pieces (206) secure the outlet (200) in place, ensuring that it does not move or otherwise reorient as the user attempts to insert or remove a plug from the body (202). The mounting pieces (206) can include "yokes" or tabs that are configured to prevent the outlet (200) from being installed too deeply into the electrical box. For example, the yokes can keep the mounting pieces (206) approximately flush with the wall during installation.

Figure 2 additionally shows that the outlet (200) can include a first power screw (208a) and a second power screw (208b) (collectively "power screws 208"). In at least one implementation, the power screws (208) allow the outlet (200) to be connected to an active power source. Additionally or alternatively, the power screws (208) can allow the outlet (200) to be connected to other active loads, such as switches, additional outlets or any other active load. The outlet (200) may include power inputs that allow a wire to be inserted directly without the need to attach the wire to the power screws (208).

Figure 2 also shows that the outlet (200) can include a first neutral screw (210a) and a second neutral screw (210b) (collectively "neutral screws 210"). In at least one implementation, the neutral screws (210) return power to the power source, completing the electrical circuit. For example, power flows from the power source to the power screws (208), through the external device via the plug, to the neutral screws (210) and back to the power source forming an electrical circuit. Additionally or alternatively, the neutral screws (210) can allow the outlet (200) to be connected to other active loads, such as switches, additional outlets or any other active load. The outlet (200) may include power inputs that allow a wire to be inserted directly without the need to attach the wire to the neutral screws (210). One of skill in the art will appreciate that such inputs remain connected to the neutral screws (210) such that a wire from another active load and connected to the neutral screws (210) is able to provide power to the additional active load.

One of skill in the art will appreciate that the power screws (208) and the neutral screws (210) can be of any desired voltage. For example, voltage can include 100V, 120 V, 220 V, 230 V or any other desired voltage. I.e., the voltage between the power screws (208) and the neutral screws (210) can accommodate any voltage preference or standard.

Figure 2 further shows that the outlet (200) can include powered terminals that comprise conductive tabs (212) and screws (208, 210). The connecting tabs (212) allow a single wire to be connected to the outlet (200) and power both of the adjacent screws. For example, the first connecting tab (212a) connects the first power screw (208a) and the second power screw (208b) such that a wire connected to the first power screw (208a) is also connected to the second power screw (208b) and vice versa. Likewise, the second connecting tab (212b) connects the first neutral screw (210a) and the second neutral screw (208b) such that a wire connected to the first neutral screw (210a) is also connected to the second neutral screw (210b) and vice versa.

The first connecting tab (212a), the second connecting tab (212b) or both can be removed during installation when connection between the adjoining screws is desired. Removal of the first connecting tab (212a) allows separate power inputs to the first power screw (208a) and the second power screw (208b). Likewise, removal of the second connecting tab (212b) allows separate neutral connections to the first neutral screw (210a) and the second neutral screw (210b). Separate connections may be desirable if the different sockets are to be placed on separate circuits, operated with a switch or should otherwise be independent of one another.

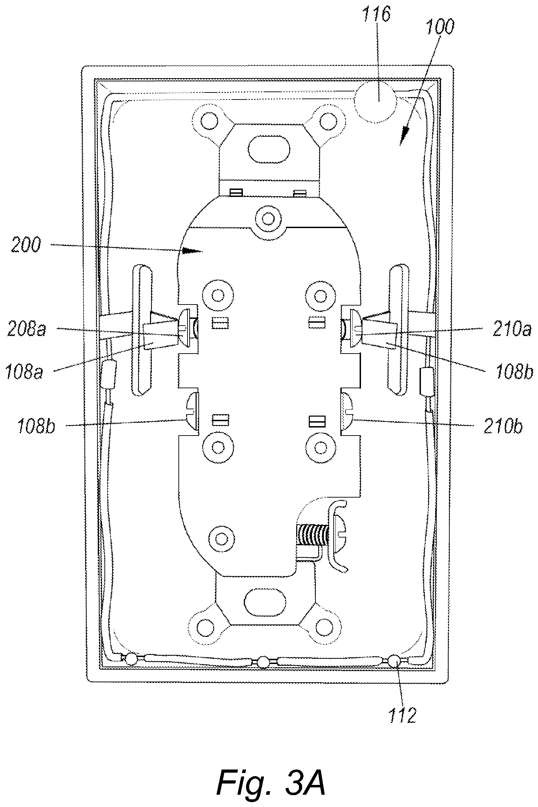

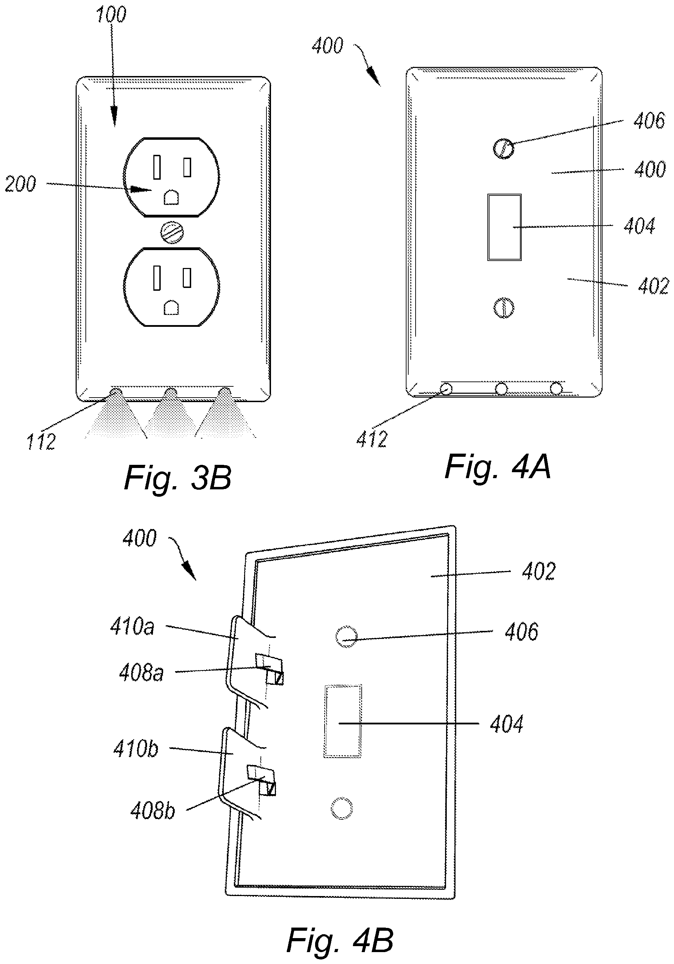

Figures 3A and 3B illustrate an active cover plate (100) in combination with an outlet (200). Figure 3A illustrates a rear view of the cover plate (100) in combination with the outlet (200); and Figure 3B illustrates a front view of the cover plate (100) in combination with the outlet (200). In at least one implementation, the active cover plate (100) is configured to be installed on the outlet (200) without the need for hardwiring the cover plate (100). In addition, the active cover plate (100) can electrically connect to the outlet (200) without occupying a socket in the outlet.

Figures 3A and 3B show that the first resilient conductor (108a) is in contact with the first power screw (208a). In at least one implementation, the first resilient conductor (108a) receives power supplied to the first power screw (208a). The power can then be delivered to a load (112) within the active cover plate (100). One of skill in the art will appreciate that the first resilient conductor (108a) making contact with the first power screw (208a) is exemplary only. The first resilient conductor (108a) can make contact with the second power screw (208b), the first connecting tab (212a) or can receive power in some other way.

Figures 3A and 3B also show that the second resilient conductor (108b) is in contact with the first neutral screw (210a). In at least one implementation, the second resilient conductor (108b) completes the circuit with the first neutral screw (210a). The electrical power is received in the first resilient conductor (108a) from the first power screw (208a), delivered to the load (112), then returned to the first neutral screw (210a) using the second resilient conductor (208b). The second resilient conductor (108b) making contact with the first neutral screw (210a) is exemplary only. The second resilient conductor (108b) can make contact with the second neutral screw (210b), the second connecting tab (212b) or can complete the circuit in some other way.

Figures 3A and 3B further show that the load (112) is active at least when power is being supplied to the first power screw (208a). For example, as long as a socket receiving power from the first power screw (208a) could be used as a power supply for a plug, the load (112) is receiving power. One of skill in the art will appreciate that if the socket is controlled by a switch then the load (112) will likewise be controlled by the switch.

Figures 3A and 3B additionally show that the battery backup (116) can complete a circuit with the first resilient conductor (108a) and the second resilient conductor (108b). That is, as long as a socket receiving power from the first power screw (208a) could be used as a power supply for a plug, the battery backup (116) is receiving power. Thus, if power is discontinued to the power screw (208a), the battery backup (116) is no longer receiving power. However, the battery backup (116) can continue to supply power to the load (112), allowing it to remain active for a time.

The example above describes the resilient conductors (108) directly contacting the power screws (208a). However, active cover plate may extract energy out of the outlet in a variety of ways. For example, the active cover plate can wirelessly couple energy out of the outlet. Various examples of wireless coupling are described below, including active cover plates that use inductive coupling to extract energy from the outlet.

The figures illustrate a National Electrical Manufacturers Association (NEMA) 5 outlet (hereinafter "a NEMA 5 outlet"). The NEMA 5 outlets (grounded and ungrounded) are in standard use in Canada, the United States, Mexico and are used in Central America, the Caribbean, Colombia, Ecuador, Venezuela, Japan, Taiwan, and Saudi Arabia. The principles described herein can be applied to a variety of other outlet types and styles, including NEMA 14-40, NEMA 14-50, JIS C 8303 and variants, European Commission for Conformity Testing of Electrical Equipment (CEE) 7/4 Schuko outlets, CEE 7/7 outlets, CEE 7/16 Europlug outlets, British Standard (BS) 546 family of outlets, BS 1363 outlets, and other outlets in use.

Figures 4A and 4B illustrate an alternative example of a cover plate (400). Figure 4A illustrates a front view of the cover plate (400); and Figure 4B illustrates a rear perspective view of the cover plate (400). In at least one implementation, the cover plate (400) can be used with an alternative electric device, such as a light switch. The cover plate (400) can be configured for use with any electrical box.

Figures 4A and 4B show that the cover plate (400) can include a faceplate (402). In at least one implementation, the faceplate (402) can mate with the switch to prevent access to the electrical box in which the switch is mounted. In at least one implementation, the one or more apertures (404) can provide access to the switch. For example, the cover plate (400) covers a portion of a switch with exposed electrical connections, but allows access the portion of the switch that is manually manipulated by a user.

Figures 4A and 4B further show that the cover plate (400) can include an attachment (406). In at least one implementation, the attachment (406) can include a screw hole or attached screw. The screw then is inserted into a bore in the switch or electrical box that holds the cover plate (400) in place relative to the switch. Additionally or alternatively, the attachment (406) can include one or more tabs that are attached to the switch or electrical box. I.e., the tabs are inserted into a hole and are retained by a flange or other mechanism within the switch or electrical box.

Figures 4A and 4B additionally show that the cover plate (400) can include a first resilient conductor (408a) and a second resilient conductor (408b) (collectively "resilient conductors 408"). In at least one implementation, the resilient conductors (408) can allow the cover plate to draw power. I.e., the resilient conductors (408) come in contact with the power connectors of the switch, drawing power as needed, as described below.

Figures 4A and 4B also show that the cover plate (400) can include a first insulating tab (410a) and a second insulating tab (410b) (collectively "insulating tabs 410"). The combination of the resilient conductors (408) and insulating tabs (410) makes up a pair of power extractors. In at least one implementation, the insulating tabs (410) can prevent the resilient conductors from forming a circuit with external materials. For example, as the resilient conductors (408) come in contact with the power connectors of the switch, they bend outward. This flexibility insures that the resilient conductors (408) remain in contact with the power connectors. However, it can also force the resilient conductors (408) toward wires, the electrical box or other materials. The insulating tabs (410) prevent the resilient conductors from contacting the wires, electrical box or other materials. In addition, the insulating tabs (410) may also prevent accidental arcing that may occur when the resilient conductors are energized.

The insulating tabs (410) can be the same material as the faceplate (402) or can be attached to the faceplate (402). I.e., the faceplate (402) and the insulating tabs (410) can be constructed of a single piece of insulating material. Additionally or alternatively, the insulating tabs (410) can be manufactured separately and then attached to the faceplate (402).

Figures 4A and 4B further show that the cover plate (400) can include a load (412). In at least one implementation, the load (412) can include any electrical device that requires power. I.e., the load 412 can include an electrical device embedded within the cover plate (400). For example, the load (412) can include lights, motion detectors, photocells, wireless nodes, blue tooth connectors, smoke detectors, carbon monoxide detectors, cameras, heat detectors, speakers, microphones or any other desired electrical device.

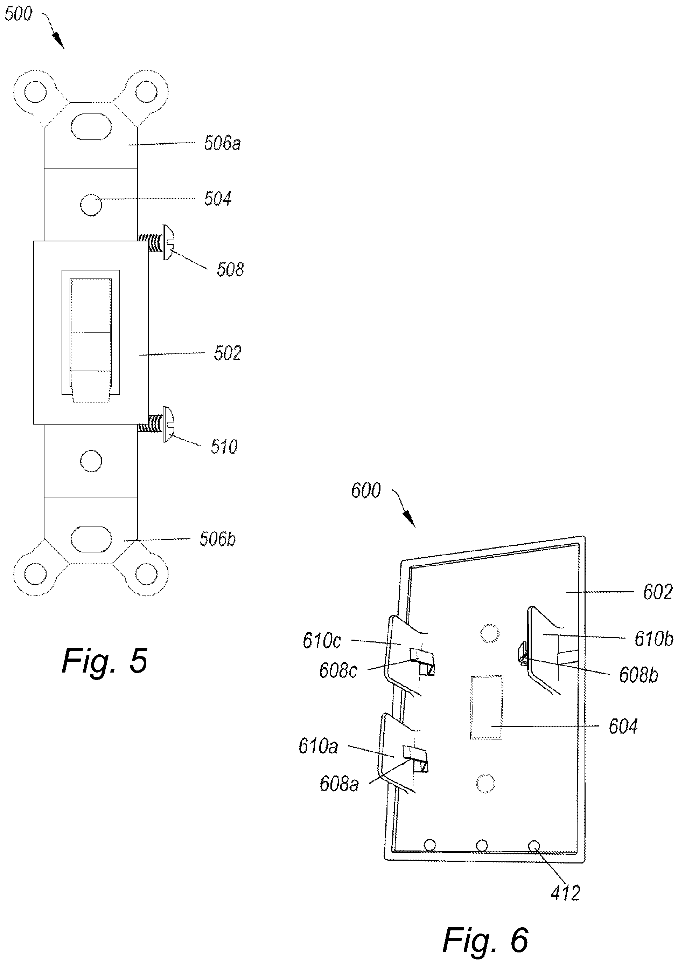

Figure 5 illustrates an example of a switch (500). In at least one implementation, the switch (500) can provide power to an external device that a user desires to turn on and off. For example, the switch (500) may be configured to allow a user to control whether a device connected to the switch is on or off. The switch (500) can be hardwired to the device or can be connected via an outlet and plug or though some other indirect connection.

Figure 5 shows that the switch (500) can include a body (502). In at least one implementation, the body (502) can include a movable portion that allows the user to control the state of the connected electrical device. For example, the body (502) can include a toggle, which can be moved as desired to change the on/off state of the connected electrical device. Additionally or alternatively, the body (502) can include a button, or touch screen or some other mechanism for detecting user control.

Figure 5 also shows that the switch (500) can include a bore (504). In at least one implementation, the bore (504) is configured to receive the attachment of a cover plate. In particular, the bore (504) can allow the attachment of the cover plate to secure the cover plate relative to the switch (500). For example, the bore (500) can include a threaded opening for receiving a screw or any other device for the cover plate attachment. The cover plate can be configured to mate with the body (502) in order to maintain the proper orientation.

Figure 5 further shows that the switch (500) can include a first mounting piece (506a) and a second mounting piece (506b) (collectively "mounting pieces 506"). In at least one implementation, the mounting pieces (506) are configured to attach the switch (500) to an electrical box. I.e., the mounting pieces (506) secure the switch (500) in place, ensuring that it does not move or otherwise reorient as the user operates the portion of the body (502) which allows the user to change the on/off state of the connected electrical device. The mounting pieces (506) can include "yokes" or tabs that are configured to prevent the switch (500) from being installed too deeply into the electrical box. I.e., the yokes can keep the mounting pieces (506) approximately flush with the wall during installation.

Figure 5 additionally shows that the switch (500) can include a power screw (508). In at least one implementation, the power screw (508) allows the switch (500) to be connected to an active power source. Additionally or alternatively, the power screw (508) can allow the switch (500) to be connected to other active loads, such as additional switches, outlets or any other active load. The switch (500) may include a power input that allows a wire to be inserted directly without the need to attach the wire to the power screw (508). One of skill in the art will appreciate that such inputs remain connected to the power screw (508) such that a wire from another active load and connected to the power screw (508) is able to provide power to the additional active load.

Figure 5 also shows that the switch (500) can include a neutral screw (510). In at least one implementation, the neutral screw (510) returns power to the power source, completing the electrical circuit. I.e., power flows from the power source to the power screw (508), through the switch, to the neutral screw (510) and back to the power source forming an electrical circuit. Additionally or alternatively, the neutral screw (510) can allow the switch (500) to be connected to other active loads, such as additional switches, outlets or any other active load. The switch (500) may include a power input that allows a wire to be inserted directly without the need to attach the wire to the neutral screw (510).

The electrical energy supplied by the power screw (508) and the neutral screw (510) can be at any of a number of voltages. For example, voltage can include 100V, 120 V, 220 V, 230 V or any other desired voltage. The voltage between the power screw (508) and the neutral screw (510) can accommodate any voltage preference or standard.

Figure 6 illustrates an alternative example of a cover plate (600). In at least one implementation, the cover plate (600) can be used with any of a number of alternative electrical devices, such as a 3-way light switch. Modifications to the cover plate (600) can allow for connection to any desired device within an electrical box, even though the actual wiring configuration may vary depending on the device.

Figure 6 shows that the cover plate (600) can include a faceplate (602). In at least one implementation, the faceplate (602) can mate with the 3-way switch to prevent access to the electrical box in which the 3-way switch is mounted. The faceplate can be made from any of a variety of materials, including insulating materials. The faceplate may have a variety of designs and configurations while still performing its function of covering the interior of the electrical box and portions of the outlet or switch within the electrical box. The cover plate can include one or more apertures (604). In at least one implementation, the one or more apertures (604) can provide access to the 3-way switch. The cover plate may be connected to the outlet/switch in any of a variety of ways, including the techniques described above.

Figure 6 additionally shows that the cover plate (600) can include a first resilient conductor (608a), a second resilient conductor (608b) and a third resilient conductor (608c) (collectively "resilient conductors 608"). In at least one implementation, the resilient conductors (608) can allow the cover plate to draw power. (i.e., the resilient conductors (608) come in contact with the power connectors of the 3-way switch, drawing power as needed, as described below).

Figure 6 also shows that the cover plate (600) can include a first insulating tab (610a), a second insulating tab (610b) and a third insulating tab (610c) (collectively "insulating tabs 610"). As discussed above, the insulating tabs (610) can prevent the resilient conductors from forming a circuit with external materials and prevent undesirable arcing. The insulating tabs (610) can be the same material as the faceplate (602) or can be attached to the faceplate (602).

Figure 6 further shows that the cover plate (600) can include a load (612). The load may be any device that uses or dissipates electrical power (i.e., the load (612) can include an electrical device embedded within the cover plate (600)). The load (612) could include any of a variety of devices, including but not limited to, lights, motion detectors, photocells, wireless nodes, blue tooth connectors, smoke detectors, carbon monoxide detectors, cameras, heat detectors, speakers, microphones, vibration/acceleration sensors, radon detectors, or any other desired electrical device.

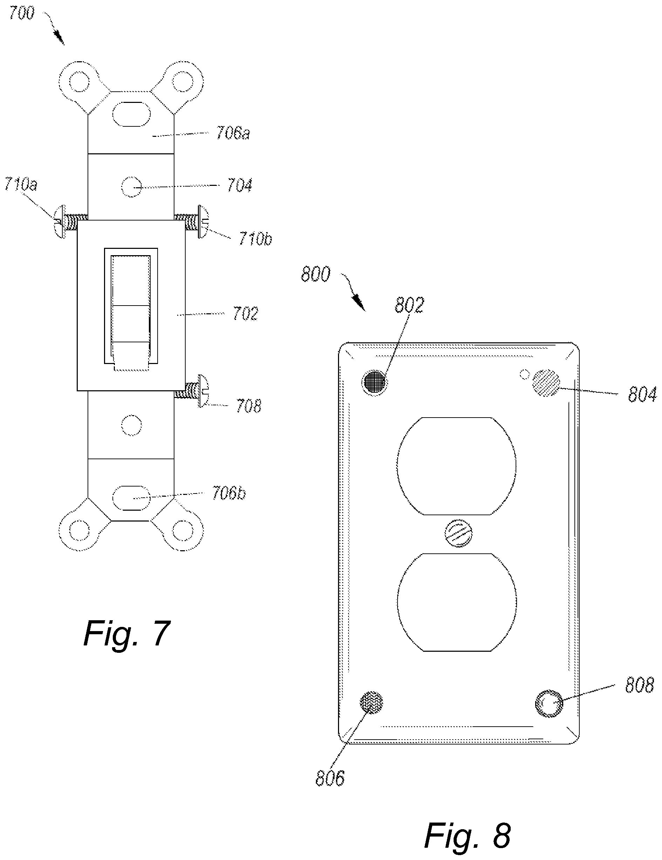

Figure 7 illustrates an example of a 3-way switch (700). In at least one implementation, the 3-way switch (700) can provide power to an external device which a user desires to turn on and off in combination with another switch (i.e., the 3-way switch (700) is configured to allow a user to control whether a device connected to the 3-way switch is on or off). The device is on when both switches are in the same configuration and off when both switches are in a different configuration. The 3-way switch (700) can be hardwired to the device or can be connected via an outlet and plug or though some other indirect connection.

Figure 7 shows that the 3-way switch (700) can include a body (702). In at least one implementation, the body (702) can include a movable portion that allows the user to control the state of the connected electrical device. For example, the body (702) can include a toggle, which can be moved as desired to change the on/off state of the connected electrical device. Additionally or alternatively, the body (702) can include a button, or touch screen or some other mechanism for detecting user control.

As discussed above with respect to other outlet and switch embodiments, the 3-way switch (700) can include a bore (704). In at least one implementation, the bore (704) is configured to receive the attachment of a cover plate. The 3-way switch may also include a an include a first mounting piece (706a) and a second mounting piece (706b) that are configured to allow the switch to be connected to an electrical box. Figure 7 additionally shows that the 3-way switch (700) can include a power screw (708). In at least one implementation, the power screw (708) allows the 3-way switch (700) to be connected to an active power source. Additionally or alternatively, the power screw (708) can allow the 3-way switch (700) to be connected to other active loads, such as additional 3-way switches, outlets or any other active load. The 3-way switch (700) may include a power input that allows a wire to be inserted directly without the need to attach the wire to the power screw (708). Figure 7 also shows that the 3-way switch (700) can include a first neutral screw (710a) and a second neutral screw (710b) (collectively "neutral screws 710"). In at least one implementation, the neutral screws (710) return power to the power source, completing the electrical circuit. Power flows from the power source to the power screw (708), through the 3-way switch, to either the first neutral screw (710a) or the second neutral screw (710b) to the other 3-way switch through the electrical device and back to the power source forming an electrical circuit.

During operation, the first resilient conductor (608a) is in contact with the power screw (708), the second resilient conductor (608b) is in contact with the first neutral screw (710a) and the third resilient conductor (608c) is in contact with the second neutral screw (710b). In at least one implementation, the first resilient conductor (708a) receives power supplied to the power screw (708). The power can then be delivered to a load (612) within the cover plate (600). The power is then returned to either the first neutral screw (710a) through the second resilient conductor (608b) or the second neutral screw (710b) through the third resilient conductor (608c).

A variety of other configurations are possible depending on the wiring of the 3-way switch (700). For example, the cover plate (600) can include circuitry to determine active terminals and route power accordingly. Additionally or alternatively, the cover plate (600) can include a mechanical mechanism that transforms motion of the switch to movement of a resilient conductor (608) to move the resilient conductor (608) to the appropriate power screw (708). In addition, other elements may be necessary at other switch locations to ensure that the circuit through the load (712) does not complete the circuit to the attached electrical device. Additionally or alternatively, the resilient conductors (608) can include a slide that allows the resilient conductors (608) to be placed in any desired position (i.e., a user can place the resilient conductors (608) in a desired position, depending on the wiring configuration of the switch to be attached to, before installation).

Figure 8 illustrates an alternative example of a cover plate (800). In at least one implementation, the cover plate (800) can be used with an alternative load. In particular, the cover plate (800) can include loads that perform additional functions, as desired. The loads disclosed herein are merely exemplary and do not limit the applicability of the principles described herein.

Figure 8 shows that the cover plate (800) can include a speaker (802). In at least one implementation, the speaker (802) can include an electroacoustic transducer that converts an electrical signal into sound that can be perceived by a user. Specifically, the speaker (802) can move in accordance with the variations of an electrical signal and causes sound waves to propagate through a medium. In particular, the speaker (802) can be used to produce sound from a data signal sent to the cover plate (800). The speaker (802) can be part of the cover plate (800) or can be an external device such as external speakers or headphones. For example, the speaker (802) can include a headphone jack.

Figure 8 also shows that the cover plate (800) can include a sensor (804). In at least one implementation, the sensor (804) can include a device that measures a physical quantity and converts it into a signal that can be read by an observer or instrument. For example, the sensor (804) can include a thermocouple that converts temperature to an output voltage that can be read by a voltmeter. In particular, the sensor (804) can include a device that receives and responds to a signal. The sensor (804) changes its output signal based on changes in the parameter being measured. The sensitivity of the sensor (804) is an indication of how much the sensor's output changes when the measured quantity changes. For instance, if the mercury in a thermometer moves 1 cm when the temperature changes by 1 °C, the sensitivity is 1 cm/°C. Ideal sensors are designed to be linear or linear to some simple mathematical function of the measurement, typically logarithmic. Additionally or alternatively, the sensor (804) can include a smoke detector, a carbon monoxide detector, a motion detector for security purposes, or any other desired sensor.

The active cover plate (800) can include a sensor (804) that can detect carbon monoxide and/or smoke from fire to alert individuals in a residential or commercial area. If needed, an extension wire (814) can run behind the wall from the outlet cover plate to a small opening higher in the wall or in the ceiling. This wire (814) is used to detect carbon monoxide and/or smoke in different areas. Controls for theses detectors are located on the cover plate (800), rendering them more accessible to the user. These sensors may be enabled with wireless communication functionality so as to communicate with and alert other detector products.

Additionally or alternatively, the active cover plate may include an infrared (IR) temperature sensor that detects heat. The output of the IR temperature can be used to detect the presence of a fire or hot gases. Additionally or alternatively, the IR temperature sensor could be used to detect the presence of people or animals in the room and/or the ambient temperature of the room. In this case, the output of the IR temperature sensor could be used to minimize energy consumption for lighting and air conditioning when a room is not occupied. Additionally, the IR temperature sensor could detect intruders by sensing a human or animal in a room that is not expected to be occupied.

A variety of other detectors could also be incorporated into the active cover plate. For example, a motion detector may be included in the active cover plate that includes one or more of the following technologies: passive infrared sensors, ultrasonic sensors, microwave sensors, tomographic sensors, or other appropriate technology. The motion detector could be used in a variety of residential and commercial applications. For example, the motion detector may detect movement in the designated area and alert a main control unit. The main control unit may take a variety of actions such as activating a video camera in the area or notifying an owner or law enforcement. The active cover plate may be directly or wirelessly connected to the main control unit, video camera, other active cover plates or other devices. The alarm and video signals could be sent to a variety of other devices, including a video monitor, a smart phone, iPad, or other device.

Figure 8 further shows that the cover plate (800) can include a microphone (806). In at least one implementation, the microphone (806) can include an acoustic-to-electric transducer or sensor that converts sound into an electrical signal. I.e., the microphone (806) can include a device that converts sound into an electrical signal for recordation and/or transmission over a network. The microphone (806) can use electromagnetic induction (dynamic microphone), capacitance change (condenser microphone), piezoelectric generation, or light modulation to produce an electrical voltage signal from mechanical vibration.

In some implementations, a speaker/microphone may be added to the active cover plates. The microphone could be used to sense noise generated in areas proximate to the active cover plate. The output of the microphone could be used for a variety of purposes including detecting intruders or baby monitoring. The active cover plate sensing the noise could route the information a main control unit, to speakers located in other active covers (for example, the master bedroom), predetermined mobile devices, television devices or to other appropriate devices. In some embodiments, an intercom system may be implemented using the microphone and speakers in the active outlets directly or in combination with other devices such as mobile phones. For example, music or sounds could be transmitted from an electronic device to a speaker in one or more active cover plates. Where multiple active cover plates are present in a given room or area, the music could be heard by the user as surround sound. By using the active cover plates as speakers in a surround sound system, the additional expense and visual clutter of surround sound speakers can be avoided. For example, a user may subscribe to a streaming music service on their mobile device. Several active cover plates that include wireless connectivity to the mobile device can receive the music from the mobile device and use speakers to broadcast the music to the user.

In some implementations, the active cover plates located in a structure may create a wireless network. Wireless signals can be passed between active cover plates. The active cover plates can act as node or repeaters that pass the wireless signal to the next active cover plate for delivery to the target device. For example, if the main central unit is too far away from a transmitting cover plate, the wireless signal can be sent to the next cover plate and the next cover plate, and so on, until the information reaches the main control unit.

Other sensors that can be included in the active cover plate include a radon detector. Radon is a heavy radioactive gas that can, after prolonged exposure, cause lung cancer. Radon is a natural by product of the decay of radioactive elements present in the soil. High radon concentrations are typically found in basements built in soil that contains radioactive material. Because radon is about eight times heavier than air, it tends to collect at lower levels of homes. Radon detectors built into active cover plates have a number of advantages. For example, cover plates in a basement area are typically mounted in the wall within about one foot of the floor. A radon detector in an active cover plate would be ideally situated to sense radon within the area because the heavy radon gas would have a tendency to sink down close to the floor and seeps into the basement through the walls and floor. Further, a radon detector in the active cover plate would be easy to install and maintain. The radon detector would not be unsightly, require external mounting, block an outlet, or cause a tripping hazard.

The radon detector in the active cover plate could sample and analyze the air quality and measure the results through the course of a collection period. Once completed, the information can be sent to other devices for review and analysis. In some embodiments, the active cover plate may directly sense that radon levels exceed a predetermined threshold and sound an alarm. Additionally or alternatively, the active cover plate may display or communicate a numeric value that describes the level of radon that was sensed. This radon data can be communicated to external devices such as cell phones, laptops, computers, web sites, or other devices.

Figure 8 additionally shows that the cover plate (800) can include a photocell (808). In at least one implementation, the photocell can include a device that detects photons. The photons may be either in the visible range (such as in a camera or a motion detector) in the infrared range (such as in a heat detector or a motion detector). For example, in a camera, the photocell can convert the photons into an electrical signal that can be used to produce an image. Additionally or alternatively, the photocell (808) can detect light levels to turn on or off other loads, such as a light.

Additionally or alternatively, the active cover plate may include any of a variety of connectors for communication or supplying electrical power to other devices. In one implementation, a Universal Serial Bus (USB) port may be placed in the active cover plate to provide power to any compatible device. For example, a number of mobile devices can be charged by drawing power from a USB port. The USB port may include Type A, Type B, Mini-A, Mini-B, Micro-A, Micro-B or any future developed connectors. One or more USB ports may be located in a variety of locations including on any of the edges or the front of the cover plate. In one embodiment, the cover plate may be slightly thickened to provide increased volume for power conditioning electronics and USB connectors. To power the USB port, electricity is extracted from the receptacle by the power extractors. The electricity is conditioned in the active cover plate to meet the USB specifications and then passed to the USB port for distribution to any connected device. A USB port is only one example of a connector that could supply power and/or communication to other devices.

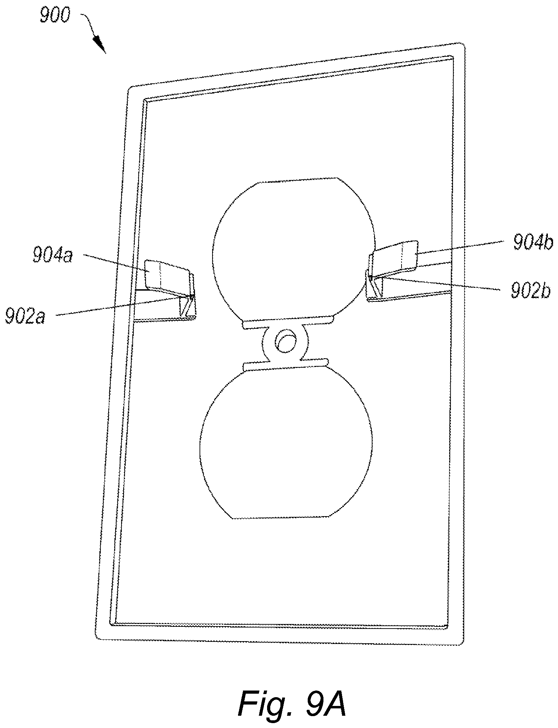

Figure 9A illustrates an alternative example of a cover plate (900). In at least one implementation, the cover plate (900) includes an alternative method of insulating the connection between the cover plate (900) and the power source (i.e., as the cover plate (900) receives electrical power from the power source, it is important to prevent arcing or other hazards).

Figure 9A shows that the cover plate (900) can include a first resilient conductor (902a) and a second resilient conductor (902b) (collectively "resilient conductors 902"). In at least one implementation, the resilient conductors (902) can allow the cover plate to draw power (i.e., the resilient conductors (902) come in contact with the power terminals of the outlet, drawing power as needed, as described below.)

Figure 9A also shows that the cover plate (900) can include a first flexible insulating cover (904a) and a second flexible insulating cover (904b) (collectively "insulating covers 904"). In at least one implementation, the flexible insulating covers (904) can prevent the resilient conductors from forming a circuit with external materials. For example, as the resilient conductors (902) come in contact with the power terminals of the outlet, they bend outward. This flexibility insures that the resilient conductors (902) remain in contact with the power connectors. However, it can also force the resilient conductors (902) toward the wires, the electrical box or other materials in the areas. By adding the insulating covers (904) to the resilient conductors, the resilient conductors can be prevented from making undesirable contact with the wires, electrical box or other materials. In addition, the insulating covers (904) may prevent arcing if the resilient conductors (902) get too close to the wires, electrical box or other materials.

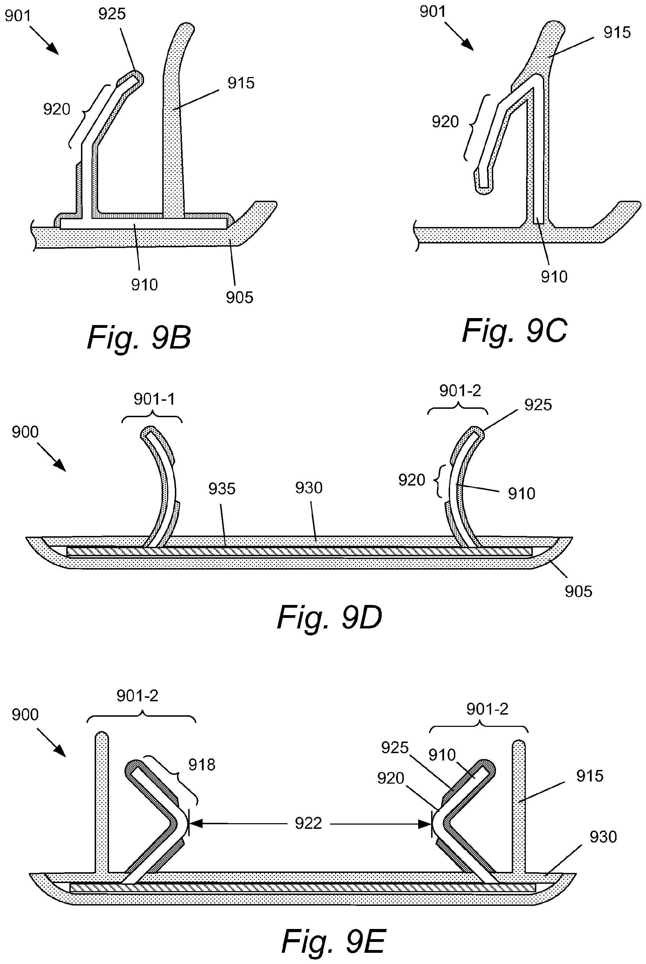

Figure 9B shows an illustrative cross sectional diagram of a power extractor (901) that is fastened to the face plate (905) of an active cover plate. In this example, the power extractor (901) includes a resilient conductor (910), flexible insulation (925) and separate insulating tab (915). The resilient conductor (910) and the separate insulating tab (915) extend rearward from the face plate (905). As discussed and shown above, this resilient conductor (910) is configured to make electrical contact with a power terminal of a receptacle. In this implementation, portions of the resilient conductor (910) that will not make electrical contact with the power terminal are coated with conformal insulation (925). An exposed portion (920) of the resilient conductor (910) makes contact with an electrified portion of the outlet. In this embodiment, a separate insulating tab (915) is positioned between the outwardly extending portion of the resilient conductor (910) and the edge of the face plate (905). The insulating tab (915) extends out from the face plate (905) farther than the resilient conductor (910). This can prevent contact between the resilient conductor (910) and surrounding materials in a variety of ways. For example, the insulating tab (915) may be interposed between the surrounding materials and the resilient conductor (910) when the active cover plate (900) is in place. In some examples, the insulating tab (915) may push surrounding materials away from the resilient conductors (910) when the active cover plate (900) is mounted over the outlet. As discussed in more detail below, the insulating tab (915) may also be useful in guiding the active cover plate (900) so that it will correctly align over the outlet. For example, the insulating tab (915) may assist in correctly placing the active cover plate (900) over the outlet by sliding over the outlet and guiding the active cover plate (900) so that the exposed portion (920) of the resilient conductors (910) contact the desired electrified portion of the outlet. The insulating tab (915) may also interact with the electrical box that houses the outlet to provide positioning guidance. In the example shown in Fig. 9B, the insulating tab (915) is angled at the top to guide the outlet into a central position between two opposing resilient conductors (910).

Figure 9C illustrates a power extractor (901) with a resilient conductor (910) and insulating tab (915) combined. The resilient conductor (910) extends upward through the insulating tab (915) and then bends and exits the insulating tab at an acute angle. This design may have a number of advantages including increased flexibility that allows the resilient conductor (910) to be displaced greater lateral distances without permanent deformation. As discussed above, the exposed portion (920) of the resilient conductor (910) makes contact with a wire hold down screw or other electrified portion of the outlet.

Figure 9D shows an active cover plate (900) that includes a face plate (905), a circuit board (935), and a back plate (930). The circuit board (935) is sandwiched between the face plate (905) and the back plate (930). The power extractors (901) in this example include with the arc shaped resilient conductors (910) extending from the circuit board (935) through the back plate (930). In this example, there are no insulating tabs. The flexible conformal insulation (925) on the resilient conductors (910) prevents undesirable electrical contact with surrounding material. The flexible conformal insulation (925) may be any of a number of materials. In some examples, the conformal insulation (925) may be a polymer material that is dip coated, brushed, or sprayed onto the resilient conductors (910) or the insulation may be heat shrink tubing placed over the resilient conductors. In one implementation, the entire surface of the resilient conductors (910) may be coated with the conformal insulation (925). Selected portions of the conformal insulation (925) may then be removed to make electrical connections between the resilient conductors (910) and the circuit board (935) and to create the exposed portion (920) that contacts an electrified portion of the outlet.

Figure 9E shows a cross sectional diagram of an active cover plate (900) that includes a back plate (930) with integrally molded insulating tabs (915). As discussed above, the insulating tabs (915), resilient conductors (910) and conformal insulation (925) make up the power extractors (901-2). The insulating tabs (915) are located between the resilient conductors (910) and the edge of the active cover plate (900) to prevent undesirable contact between the resilient conductors (910) and surrounding materials.

For example, the insulating tabs prevent the power extractors from contacting the electrical box that the receptacle is installed in. In many commercial installations, the electrical box is metal and if a power extractor were to contact the metal box, it could cause a short. In the embodiment shown in Fig. 9E, the resilient conductor (910) is protected from electrically shorting to the electrical box by both the insulating tab (915) and by the insulating coating (925) over the resilient conductor. The insulating tab may be flexible so that it can conform around or deflect when obstacles are encountered. For example, sheet rock may protrude over the edge of the electrical box. Because the insulating tab is flexible, it can deform around this obstruction and still allow the cover plate to correctly fit to the receptacle and still provide the desired insulating function.

In some embodiments, the insulating tabs may have a height and width greater than the height and width of the resilient conductor. This ensures that the resilient conductor, while being able to be deflected independently from the insulating tabs, cannot be deflected so far that it contacts materials that are external to the cover plate and receptacles (i.e. the outlet box or wall materials). The insulating tabs may be formed in a variety of ways. For example, the insulating tabs may integrally molded components of a back plate that connects to the face plate. In other implementations, the insulating tabs may be formed separately and mechanically connected to either the faceplate or the back plate. In other embodiments, the insulating tabs may have a hinged connection with either the faceplate or the back plate such that during shipping or storage the insulating tabs lie flat, but during installation and use the insulating tabs are locked in an extended position.

In some embodiments, the resilient conductors (910) may have additional features to ensure proper contact with dirty, coated, or corroded power terminals and screws. For example, the power terminals and screws may be accidentally painted during construction or remodeling. In a typical painting scenario, the painter removes the cover plates to prevent them from being painted and to allow area under the cover plates to be painted. This exposes the interior of the electrical box, including the screw terminals. The painter may cover the outlet faces with tape. This tape may or may not protect the screw terminals.

If the screw terminals become coated with paint, the resilient conductors (910) may not make reliable electrical contact. In one embodiment, the issue can be resolved by roughening the surface of the resilient conductors (910) or insulation (925) so that as the surface of the resilient conductor or insulation moves over the screw terminal it scrapes or abrades the paint or other corrosion off the screw or other portion of the terminal. Removing the paint allows a reliable electrical contact to be made between the exposed portion (920) of the resilient conductor (910) and the screw terminal. The surfaces of the resilient conductor and/or insulation may be roughened in a variety of ways. For example, the surface of the resilient conductor could be roughened by stamping, milling, raising burrs, or other techniques. The surface of the insulation may be roughened through the addition of nonconductive materials such as aluminum oxide grains to the outer surface of the insulation. A variety of other techniques may also be used.

The active cover plate (900) includes two resilient conductors (910) with exposed potions (920) on their inner sides. The resilient conductors (910) face each other and are configured to contact terminals on either side of an electrical receptacle. In one implementation, the distance (922) between the exposed portions (920) of the resilient conductors (910) is less than a distance between outer surfaces of an outer surface of a first electrical terminal and an outer surface of a second electrical terminal of the electrical receptacle. At least a portion (918) of the resilient conductors are angled outward toward the edges of the faceplate, such that contact between the outwardly angled portions and the receptacle deforms the resilient conductors outward and positions the exposed portions (920) of the power extractors to contact terminals on the receptacle.

The principles and systems described above illustrate power extractors being used to make direct electrical contact and portions of the conductive terminals at the side of an outlet or switch. There are a variety of ways that electrical energy could be transferred from the outlet to the active cover plate by power extractors.

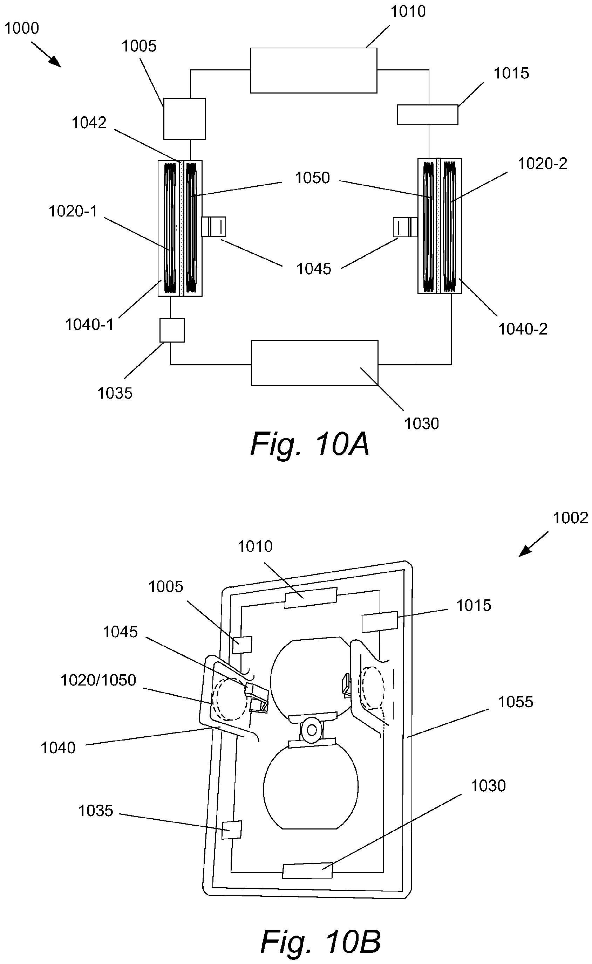

Figures 10A-14C show a number of illustrative systems and principles that use power extractors with inductive coils to inductively couple electrical energy out of a receptacle.

Figure 10A is a schematic of an inductive system (1000) for transferring electrical power out of an outlet to an active cover plate. Figure 10B is a perspective view of an active cover plate (1002) with the inductive coil system (1000) placed in the cover plate (1055). The inductive system (1000) includes two separate electrical circuits that are inductively coupled. In this example, a first electrical circuit includes two high voltage coils (1050) and resilient conductors (1045). The upper portion of the first circuit may include a number of optional circuit elements, including power conditioning (1005), high voltage load (1010), and a switching module (1015). The switching module (1015) may be used to selectively allow power to flow through the high voltage portion of the circuit. For example, the switching module (1015) may include a photo sensor, magnetic switch, wireless switch or other mechanism for selectively controlling power flowing through the high voltage portion of the circuit. The high voltage load (1010) may be any of a number of electrical devices, including lights, sensors, actuators or other devices. The power conditioning module (1005) modifies the electrical energy extracted from the outlet so that it can be used by the high voltage load (1010).

The resilient conductors (1045) may have a variety of configurations, including the contacts shown above. Electrical energy is extracted from the outlet by electrical contacts (1045) that contact either side of the outlet. The electrical energy passes from a first contact, through a first high voltage coil, through the upper portion of the first circuit, through a second high voltage coil and back into the outlet through the second contact.

A low voltage portion of the circuit is inductively coupled to the high voltage circuit by placing low voltage coils (1020-1, 1020-2) in proximity to the high voltage coils (1050). The energy flowing through the high voltage coils (1050) induces a lower voltage in the low voltage coils (1020) through electromagnetic coupling. In this example, the low voltage coils (1020) and high voltage coils (1050) are both embedded in the insulating tab (1040) and are separated by an electrical insulator (1042). In the low voltage portion of the circuit, electrical energy flows between the low voltage coils (1020) and through a low voltage power conditioning circuit (1035) and a low voltage load (1030). The low voltage power conditioning circuit (1035) may include diodes, capacitors, and other devices to convert an alternating current to a direct current. The low voltage load (1030) may be any of the loads described above, including lights, sensors, actuators or other devices.

In this example, the power extractors are made up of the resilient conductors (1045), the high voltage coils (1020), the low voltage coils (1040), the electrical insulator (1042) that separates the coils, and the insulating tabs (1040) that encapsulates the high and low voltage coils. The configuration of the low and high voltage coils (1020, 1050) can be selected to produce the desired voltage and current flows. For example, the voltage induced in the low voltage coils (1020) is proportional to a ratio of the turns between the high voltage coils (1050) and low voltage coils (1020). By adjusting the number of coils in the low voltage coil (1020) and/or high voltage coil (1050), the voltage in the low voltage coils (1020) can be adjusted to the desired level. The amount of current flowing through the high voltage coil (1050) can be adjusted in a number of ways, including selecting a resistance of the coil or inserting resistance into the high voltage current path in the power condition module (1005), switching module (1015), or high voltage load (1010).

Figure 10A and 10B show only one illustrative example of an inductive coil system. A variety of other configurations could be used. For example, electrical energy could be coupled to the low voltage circuitry using a single pair of coils. In some examples, the high voltage portion of the circuit may not include a switching module, a power conditioning module, or a high voltage load. The low voltage portion of the circuit may not require a power conditioning module because the coils have been configured to transmit power at the desired level.

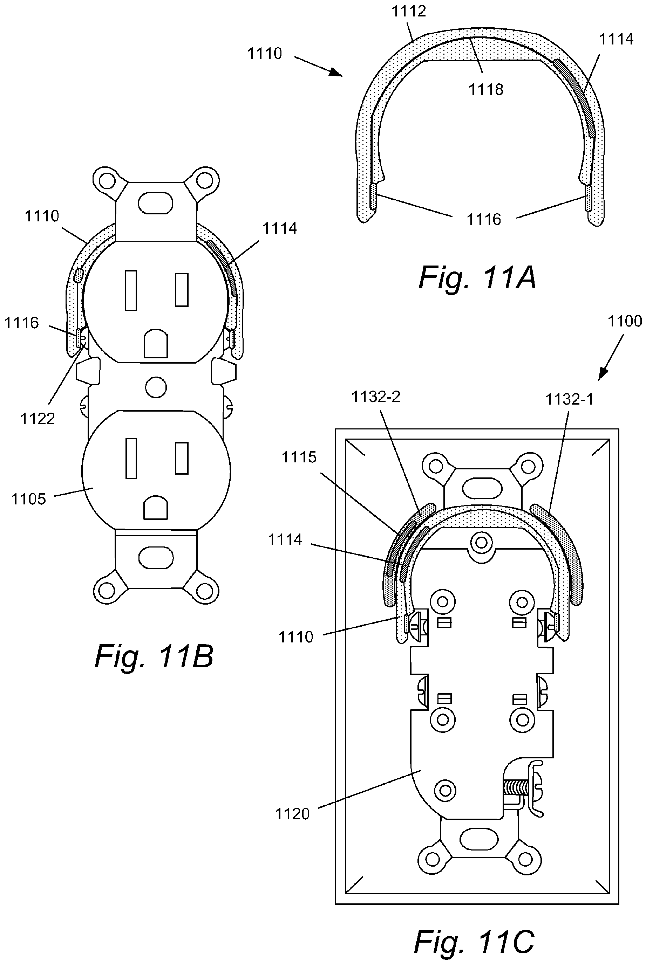

Figures 11A-11C show an alternative embodiment of an inductive coil system. In this example, an inductor clip (1110) snaps around the upper perimeter of the outlet (1105). As shown in Fig. 11A, the inductor clip (1110) includes a flexible body (1112), a high voltage coil (1114), electrical contacts (1116) and an electrical conductor (1118). When the inductor clip (1110) is snapped around upper perimeter of the outlet (1105), as shown in Fig. 11B, the contacts (1116) connect with the electrified terminals (in this example screws (1122)) on either side of the outlet (1105). The flexible body (1112) maintains spring tension on the contacts (1116) to ensure proper electrical connection between the contacts (1116) and the screws (1122). In this example, a small amount of electricity flows through the high voltage coil (1114) continuously when the inductor clip (1110) is in place. The amount of current flowing through the inductor clip (1110) can be adjusted by adjusting the amount of resistance in the inductor clip (1110). In other embodiments, there may be a switching module that controls the flow of electricity.

Figure 11C is a rear view of an active cover plate (1100) connected to the outlet (1120). The active cover plate (1100) includes two insulating tabs (1132) that interface with the inductor clip (1110). In this example, one of the insulating tabs (1132-2) is a power extractor that includes a low voltage coil (1115) that is inductively coupled to the high voltage coil (1114) in the inductor clip (1110). The other insulating tab (1132-1) serves as a mechanical support for the active cover plate (1100). The active cover plate (1100) may include a number of other components, such as power conditioning modules, low voltage loads, and other devices that are powered by inductively coupled electrical power.

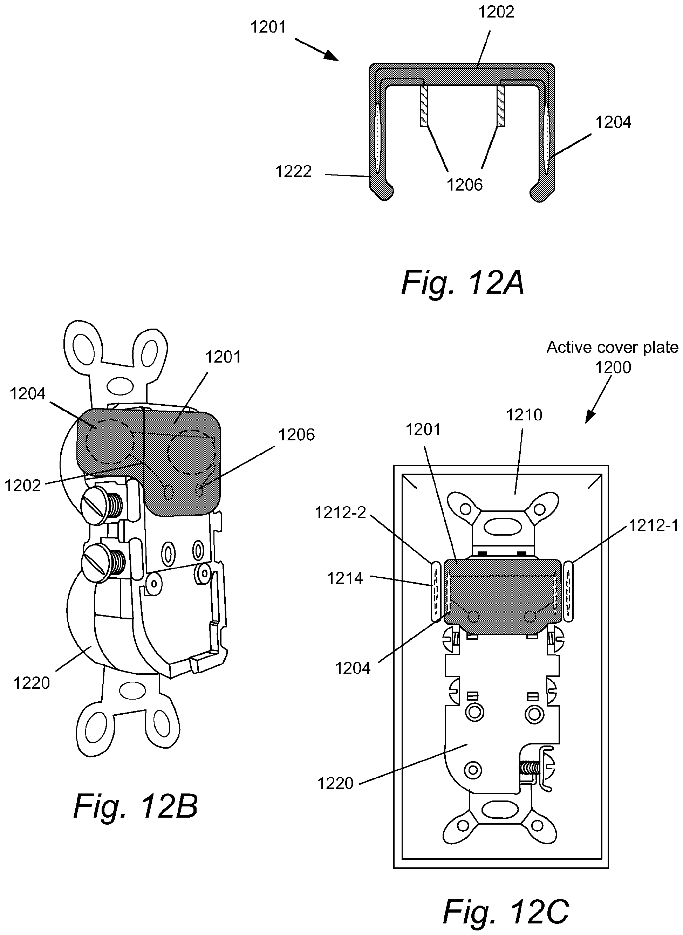

Figures 12A-12C show an alternative example of an inductively coupled system for an active cover plate (1200). In this example, a rear attach bracket (1201) connects to the rear of the outlet (1220) via stab-in connectors. Stab-in connectors are present on the rear of most outlets and some switches. The stab-in connectors are designed to allow an electrical connection to be made between household wiring and the outlet without the need to tighten or loosen screws. To use a stab-in connector, a short potion of the household wire is stripped and then forced into the orifice of the stab-in connector. As the stripped portion of the wire is forced into the orifice, the stripped portion of the wire makes electrical contact internal conductors in the outlet. The wire is prevented from backing out of the orifice by an angled blade that engages with the bare wire.

As shown in Fig. 12A, the rear attach bracket (1201) includes a flexible body (1222), at least one high voltage coil (1204), two stab-in prongs (1206) and conductors (1202) connecting the high voltage coils (1204) to the stab-in prongs (1206). In this example, the rear attach bracket (1201) includes two coils, one on either side. Fig. 12B shows the rear attach bracket (1201) connected to the back of the outlet (1220). The stab-in prongs (1206) have been forced into the stab-in connectors on the back of the outlet (1220) to make connections with the electrified conductors inside the outlet (1220). This allows electrical energy to flow through the stab-in prongs (1206), conductor (1202), and high voltage coils (1204).

Figure 12C shows the rear attach bracket (1201) connected to the back on an outlet (1220) and an active cover plate (1200) inductively coupling electrical energy out of the rear attach bracket (1201). The active cover plate (1200) includes two low voltage coils (1214) that are embedded in insulating tabs (1212) that extend rearward from the faceplate (1210). The active cover plate (1200) may also incorporate any of a number of device discussed above, including power conditioning, sensing, lights, speakers, or other elements powered by the inductively coupled electricity. In this example, the power extractor comprises the insulating tabs (1212) and the low voltage coils (1214).

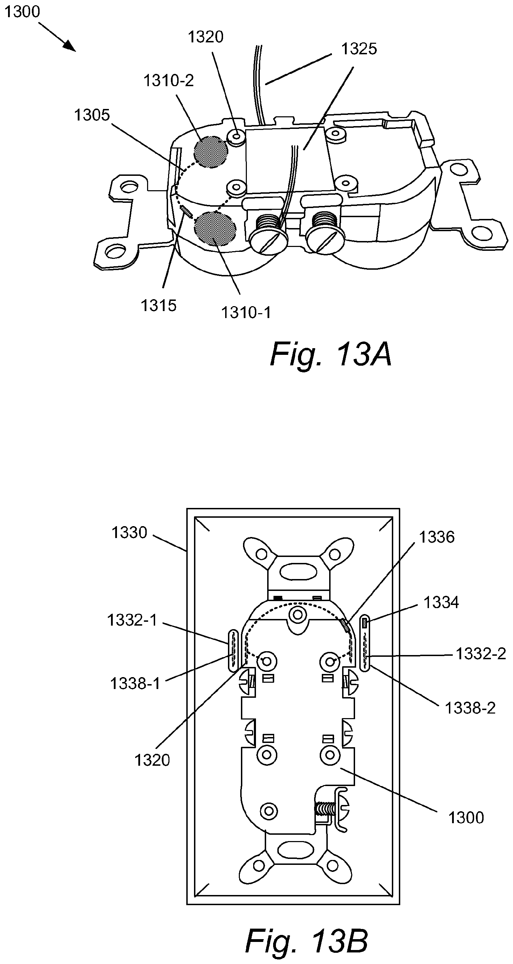

Figures 13A and 13B show an electrical outlet (1300) that includes internal inductive coils (1310). Two power wires (1325) are shown connected to the screw terminals either side of the outlet. The internal inductive coils (1310) are located near the perimeter of the outlet (1300). The internal inductive coils (1310) are connected to internal resilient conductors (1305). In this example, the inductive coils (1310) are shown as being electrically connected to the internal resilient conductors (1305) of the stab-in connectors (1320).

In one implementation, a magnetic reed switch (1315) is placed in the line between the coils (1310). A magnetic reed switch (1315) is ordinarily open and no current flows through the coils (1310). When a magnet is placed near the reed switch (1315), the reed switch (1315) closes and allows electrical current to flow.

Fig. 13B shows an active cover plate (1330) placed over the outlet (1300) with internal coils. The active cover plate (1330) includes two insulating tabs (1332). In this example, both insulating tabs (1332) have embedded low voltage coils (1338). The tab (1332-2) nearest the reed switch (1336) also contains a permanent magnet (1334). The permanent magnet (1134) closes the reed switch (1336) inside the outlet (1300) to allow electrical energy to flow through the high voltage coils (1320) in the outlet (1300). Electrical energy can then be inductively coupled out of the high voltage coils (1320) and into the active cover plate (1330). Thus, when an active cover plate (1330) is not in place over the outlet (1300), there is no energy dissipation in the outlet (1300). When the active cover plate (1330) with an embedded magnet (1334) is placed over the outlet (1300), the reed switch (1336) closes and allows electrical current to flow through the device. In this example, the power extractors comprise the insulating tabs (1332), the low voltage coils (1338) and the permanent magnet (1134).

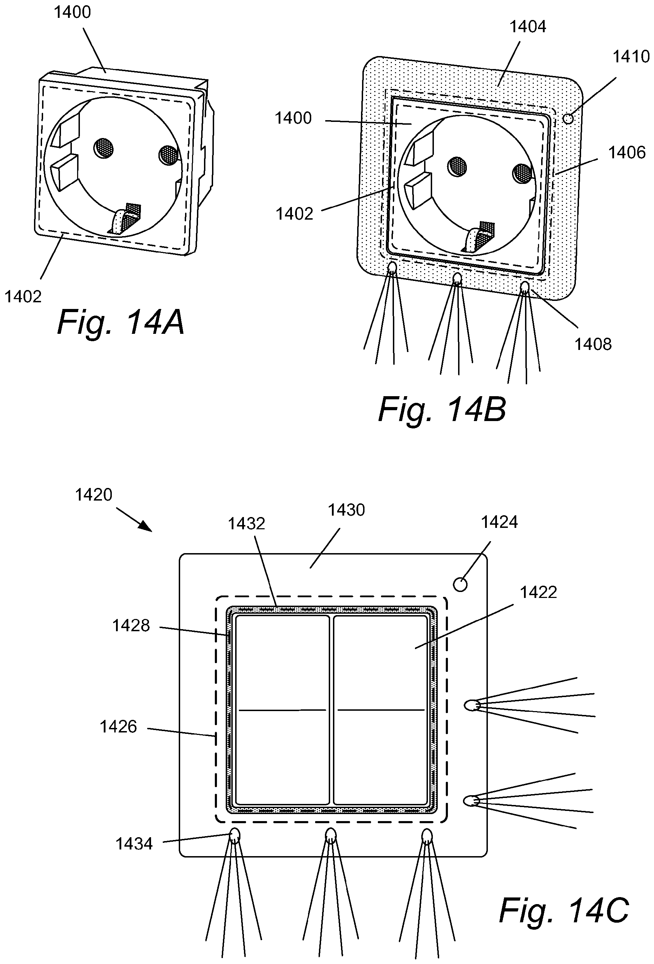

Figures 14A-14C show another example of an inductive coupling between an outlet and a cover plate. Figure 14A shows an outlet (1400) configured to accept a Europlug style cord. The outlet (1400) includes an internal coil (1402) around its perimeter.

Figure 14B shows a cover plate (1404) that surrounds the outlet (1400). The cover plate (1404) contains a low voltage coil (1406) that inductively extracts power from the internal coil (1402). This powers any of a number of devices that may be present in the cover plate (1404). In this example, the cover plate (1404) includes a light sensor (1410) and a number of lights (1408). However, the cover plate (1404) could include any of a number of components, including those described above. For example the cover plate (1404) could include a smoke detector, speaker, camera, wireless connectivity, carbon monoxide detector, or other device.

Figure 14C shows a switch assembly (1420) that includes a double gang of switches (1422). A bezel (1432) runs around the perimeter of the switches and is an integral part of the switch assembly. In this example, a high voltage coil (1428), represented by a dashed line, has been formed inside the bezel (1432). After the switches (1422) have been installed in the outlet box, an active cover plate (1430) can be installed around the switches (1422). Around the inner perimeter of the active cover plate (1430) a low voltage coil (1426) has been installed to inductively extract power from the high voltage coil (1428). In this example, the active cover plate (1430) includes a light sensor (1424) and a number of lights (1434). The lights (1434) may be arranged in any of a variety of locations and point in any direction. In this example, three of the lights are arranged to point downward to illuminate the floor and two of the lights point to the right to illuminate an adjacent doorway. In these examples, the power extractor comprises the low voltage coil (1406) in the cover plates for the outlet or the low voltage coil (1426) in the cover plate for the switches.

Inductive coupling of energy out of the outlet may have a number of advantages. Where the high voltage coils are an integral part of the outlet, the active cover plate does not include any high voltage components. This can reduce the design requirements of the active cover plate. Further, simple modifications of the outlet, such as attaching a clip containing high voltage coils to the outlet, allows production outlets to have the desired inductive coupling capabilities.

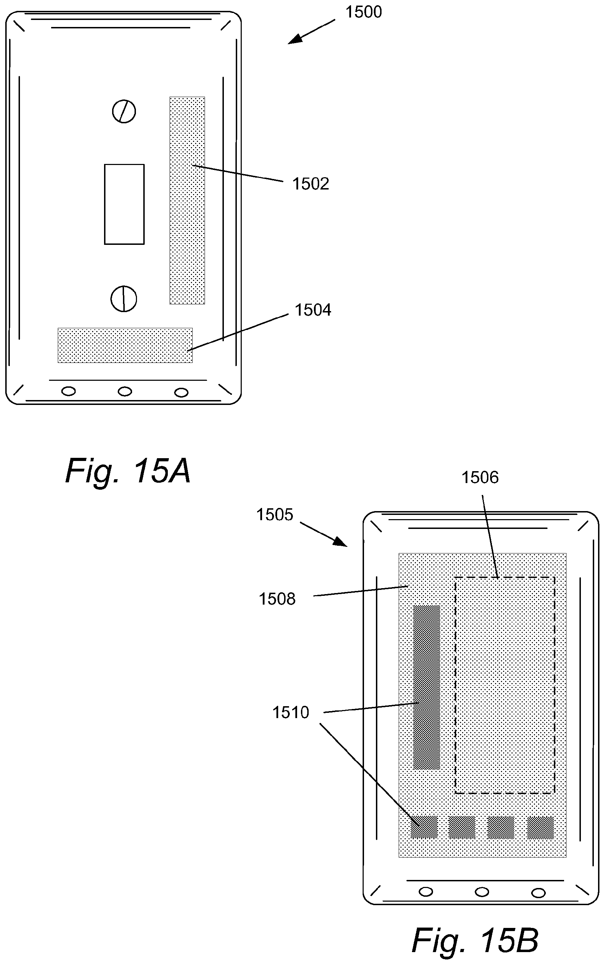

Figure 15A and 15B show embodiments of active cover plates that include touch sensitive surfaces and/or active display elements. Fig. 15A shows an active cover plate (1500) that includes a horizontal touch sensitive control area (1502) and a vertical touch sensitive control (1504) area. The touch sensitive control areas may operate on a number of principles, including capacitive, resistive, and surface acoustic wave technologies. For example, the touch sensitive control areas may be a capacitive touch button. The touch sensitive areas (1502, 1504) may be designated for easy identification by the user in a variety of ways, including creating a surface with a different texture or coloring/lighting the touch sensitive areas.

Figure 15B shows an active cover plate (1505) that includes a touch screen (1508) on its front surface. The touch screen (1508) may be used both to display information and to receive commands. The display and response of the touch screen (1508) can be adjusted to implement the desired functionality. The touch sensitive control areas (1510) may be used in a variety of ways, including activating and controlling functionality of the switch, controlling devices embedded in the active cover plate (1505), or to communicate with other devices. For example, an active cover plate (1505) may be part of a home security system and report to the user that an abnormality has been detected. The display area (1506) of the active cover plate (1505) may display a light or generate a sound that communicates the abnormality. The user can then use the touch sensitive control areas (1510) to address the abnormality. For example, the user may silence the alarm, activate lighting or cameras, or take other appropriate action.

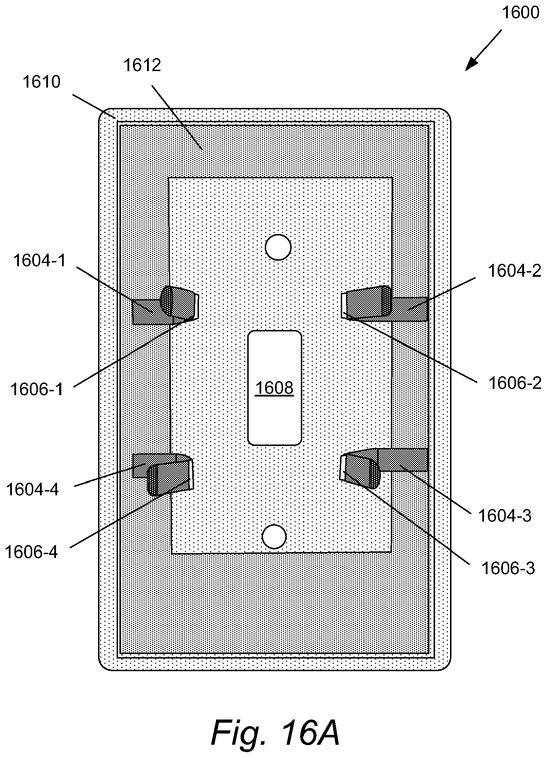

Figure 16A is a rear perspective of an illustrative active cover plate (1600). In this implementation, the active cover plate (1600) is a universal switch cover plate (1610) that includes a rectangular opening (1608) for the switch toggle to extend through. The cover plate is fitted with four insulated power extractors (1604-1, 1604-2, 1604-3, 1604-4). The four insulated power extractors (1604) are connected to the circuit board (1612) and are covered with a protective material with narrow openings that expose a portion of each of the resilient conductors. These exposed portions (1606) of the resilient conductors draw power from electrical terminals on a receptacle. The protective material surrounding the resilient conductors could be made from a wide variety of flexible insulating materials, including plastics and rubber compounds. In this implementation, a circuit board (1612) is connected directly to the face plate and the power extractors are connected to the circuit board (1612). The cover plate (1600) can be connected to a single pole switch, a three-way switch, or a four-way switch. The four insulated power extractors (1604) allow power to be extracted from the appropriate electrical terminals of any of these switches. In most embodiments, one or more of the insulated power extractors (1604) will not be connected to an active electrical terminal. However, the active cover plate (1600) is configured to direct electrical power from the powered terminals to the load in the active cover plate.

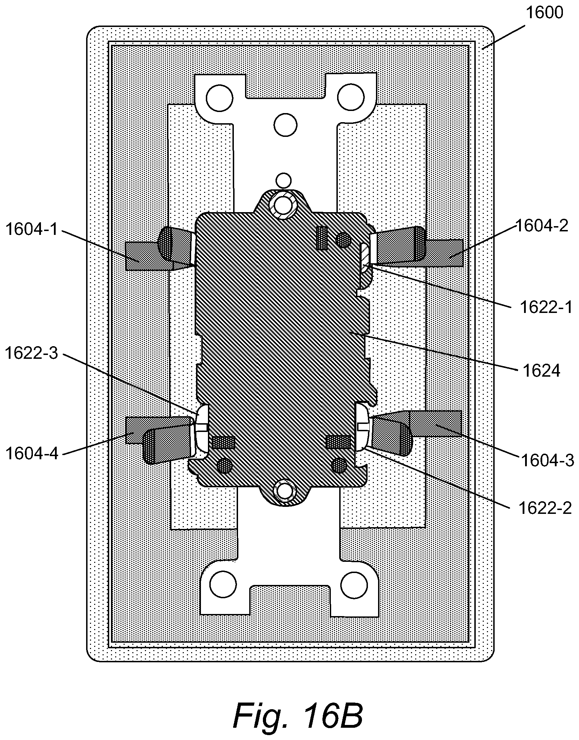

Figure 16B is a rear view of the illustrative active cover plate (1600) shown in Figure 16A that has been connected to a three way electrical switch (1624). Three way electrical switches (1624) are used for multi-way switching of electrical loads. For example, this allows lighting in a hallway, stairway, or large room to be controlled from two locations. Externally the three way switch (1624) appears similar to a single pole switch, but internally the three-way switch is has a single pole, double throw configuration. When two three-way switches are connected to a load, toggling either switch changes the state of the light from OFF to ON, or from ON to OFF. To support this functionality, the three-way switches include three screw terminals for three different wires to the switch. There is no preferred orientation for installing the three-way switch. There is no difference in the functionality or appearance of a three-way switch that is installed right side up or up side down. Consequently, an active cover plate (1600) that is installed over a three way switch (1624) can include four power extractors (1604-1, 1604-2, 1604-3, 1604-4) so that there are two power extractors (1604) positioned to contact the powered screw terminals (1622-1, 1622-2, 1622-3) regardless of the orientation of the three way switch (1624). In some examples, the active cover plate (1600) may include circuitry configured to switch internal connections so that the load in the active cover plate (1600) is connected to the powered power extractors (1604).

Figure 16B is a rear view that shows how the exposed portions of the power extractors (1604) connect with the screw terminals of the three way switch. In this example, the two bottom power extractors (1604-3, 1604-4) connect to two of the screw terminals (1622-2, 1622-3). The upper power extractor on the right (1604-2) connects to a screw terminal. There is no screw terminal on the three way switch (1620) for the upper left power extractor (1604-1) to contact. If the three way switch were installed upside down, location of the screw terminals would be reversed, with two screw terminals at the top and only one screw terminal at the bottom. Thus, Figure 16B illustrates an active cover plate that include at least three power extractors where one of the power extractors does not contact electrically powered terminal on the receptacle when the receptacle is in a first position with respect to the faceplate. However, in a second inverted position, the third power extractor contacts an electrically power terminal on the receptacle.

Although the power extractors illustrated in Figs. 16A and 16B show an insulated conductive strip, other types of power extractors could be used. For example, a power extractor may include an insulating tab and a resilient conductor that do not have insulating covers. In other implementations, the power extractors may include one or more inductive coils.

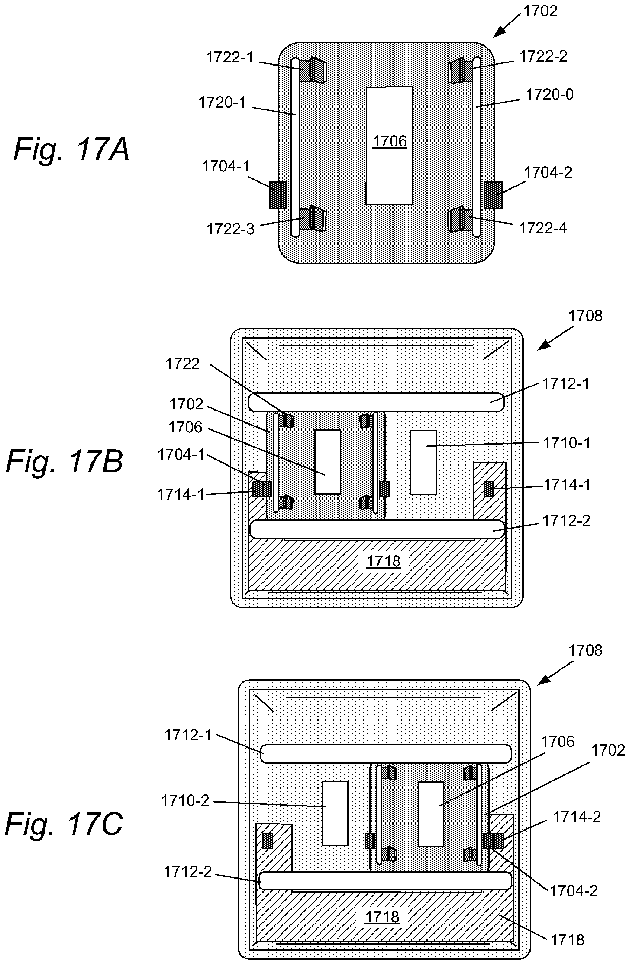

Figures 17A-17C are diagrams of an adjustable slider (1702) and the double switch active cover plate (1708) to which it is attached. Figure 17A is a plan view of an adjustable slider (1702). In the center of the adjustable slider (1702) is a rectangular opening (1706) designed to accommodate a toggle lever of an electrical switch. The adjustable slider (1702) also includes a number of resilient conductors (1722) that are connected with two or more powered terminals when the slider plate (1702) is placed over a switch. Two insulating tabs (1720) extend outward from the slider plate (1702) and serve the same purpose as the insulating tabs described above. On both sides of the adjustable slider (1702) is an electrical connector (1704-1, 1704-2) that is used to transfer power to a load in an active cover plate (1708). In this embodiment, the power extractors include the resilient conductors (1722) and the insulating tabs (1720).

As shown in Fig. 17B, the adjustable slider (1702) can be connected to an active cover plate (1708) by upper and lower rails (1712-1, 1712-2). The active cover plate (1708) is configured to fit over a dual gang switch. The active cover plate (1708) has two rectangular openings (1710) for the switch toggles to extend through. The slider plate (1702) is configured to slide along the rails (1712) so that it can make electrical connections to either of the switches (1710). Figure 17B shows the slider plate (1702) moved all the way to the left so that its opening (1706) aligns with the underlying opening in the active cover plate (1708). The connector (1704-1) on the slider plate (1702) mates with a corresponding connector (1714-1) mounted on the circuit board (1718) of the active cover plate (1708). This allows electrical energy to be extracted from the desired electrical switch and conveyed to the electrical components on the circuit board (1718).

In Figure 17C, the adjustable slider (1702) has been moved along the upper and lower rails (1712-1, 1712-2) to the right, over the opposing switch opening (1710-1) so that the opening (1706) aligns with the underlying opening in the active cover plate (1708). The right electrical connector (1704-2) on the adjustable slider (1702) is in contact with one of the active cover plate's mounted connectors (1714-2). The mounted connector (1714-2) is attached to the circuit board (1718) of the active cover plate (1708). As described above, when the resilient conductors make contact with the mounted connector, an electric circuit is completed, from which the active cover plate (1708) can draw power.

This adjustable slider functionality can be useful to consumers that have a gang of switches that are grouped together. For example, a gang of three switches in a room may allow for individual control of the main light, track lighting and ceiling fan. Where the active cover plate is attached to a switch, some of the electrical terminals on the switch may not have electrical power at all times. For example, two switches may be connected to the same light. In a room with two entrances a first switch may be next to the first entrance and a second switch may be next to a second entrance. This allows the light to be turned on or off from either entrance. To implement this functionality, a three way wiring configuration can be used. The three-way wiring ensures that the light or other load is energized only when the both of the switches are in the same configuration. When the switches are in different configurations, one of switch terminals on each of the switches is not energized and no power flows to the load. However, it may be desirable for the active cover plate to draw power from the switch even if the load is not active. For example, if the active cover plate is a night light, it can be advantageous for night light to remain illuminated when the main light in the room is off. As discussed above, one or more of the terminals of the switch may not be energized when the switch is off. To accommodate this, the active cover plate is configured to draw power from the outlet even when one of the three terminals is not energized, by extracting electrical energy from an activated terminal and back feeding a low amount of electrical energy through the load to a neutral terminal. For example, if the load is a light, the active cover plate may draw a small amount of power from a powered terminal. The small amount of power passes through the light and active cover plate back to a neutral terminal on the switch. This small amount of power is sufficient to allow the active cover plate to operate. However, the small amount of power is not sufficient to cause the main light or other load in the room to activate. This procedure is called "back feeding" and allows the active cover plate to draw small amounts of power from three way switches that are off.

In these situations, it may be advantageous for an active cover plate to be reconfigurable so that electrical power is drawn from the desired switch. When a user installs an active cover plate, the user may choose which switch is desired to control the ON/OFF functionality of the active cover plate. The user may move the adjustable slider across the rails to the desired switch opening, 1710-1, or 1710-2. The configuration shown in Figs. 17A-17C could be used in conjunction with any of a variety of multi-gang switches, including double gang, triple gang, or four gang switches.

Although the power extractors illustrated in Figs. 17A-17C show insulated conductive strips with insulating tabs, other types of power extractors could be used. For example, the power extractors may include an insulating tab and a resilient conductor without an insulating covering or may include an insulated conductor without the insulating tab. In other implementations, the power extractors may include one or more inductive coils.

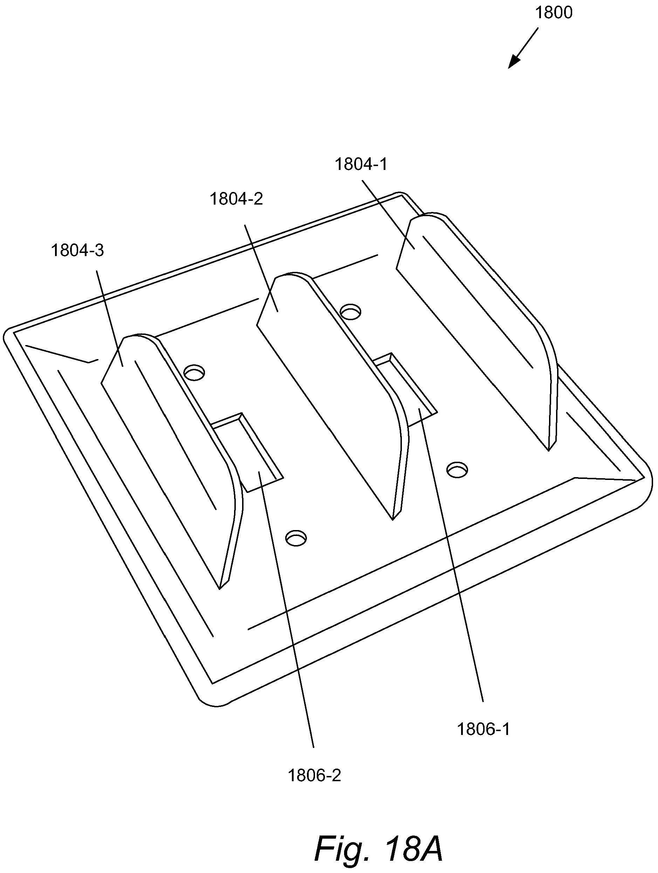

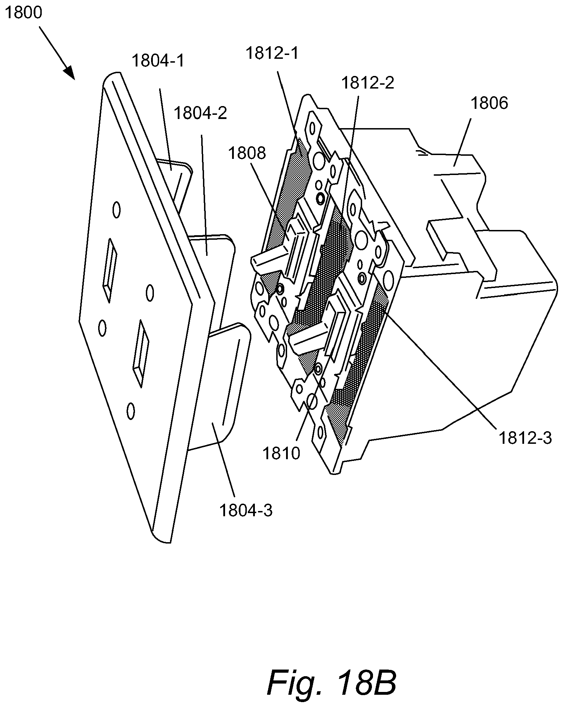

Switch covers with a variety of other configurations could be used for ganged switches. For example, Figure 18 is a perspective view of a two-switch active cover plate (1800) with three tabs (1804-1, 1804-2, 1804-3). For purposes of illustration, other components in the power extractors are not shown in this drawing. These tabs (1804) are fixed on the active cover plate (1800) parallel to one another, with one tab (1804-2) centered between the two rectangular switch openings (1806-1, 1806-2) and two tabs (1804-1, 1804-3) on either side of the openings (1806). The tabs (1804) can be made of thin plastic, reinforced plastic, ceramic, rubber or various other materials.

The tabs can serve a variety of functions, including those described above. Specifically, the tabs can act as insulating barriers that prevent charged resilient conductors from contacting other elements. The tabs may also serve to protect the resilient conductors and other components in the active cover plate from damage. The tabs may also provide guidance and alignment during placement of the active cover plate over the switch. For example, the tabs can help ensure proper alignment of the active cover plate over the switch before the resilient conductors are forced against components of the switches. This reduces the chance that the resilient conductors will be bent or damaged by poor initial positioning of the active cover plate.

In Figure 18A, the tabs (1804) are tapered, with the base of the tabs (1804) being longer than the leading edge of the tabs. Additionally, the outer tabs lean inward, towards the electrical switches. Fig. 18B shows the two-switch active cover plate (1800) being inserted into an electrical box supporting two switches (1808, 1810). The tabs (1804) on the active cover plate (1800) are configured to fit into three cavities (1812) that are on the sides of the switches (1808, 1810). The taper of the tabs (1804) is helpful in alignment because the smaller leading edges are easier to initially align and insert into the cavities. As the two-switch active cover plate (1800) continues to be moved forward toward the electrical box (1806), the tabs (1804) are inserted deeper into the cavities (1812). The wider base portions of the tabs (1804) provide increasingly tight alignment to ensure that the resilient conductors are properly positioned over the screw terminals.

Additionally, the inwardly leaning angle of the outer tabs (1804) can assist the user in inserting the tabs (1804) into the cavities (1812) by providing horizontal alignment between the electrical box (1806) and the active cover plate (1800). Initially, the leading edges of the tabs (1804) easily fit into the cavities (1812). As the two-switch active cover plate (1800) continues to be moved toward the electrical box (1806), the angle of the tabs (1804) forces the two-switch active cover plate (1800) into tighter horizontal alignment. This tapering and angling of the outer tabs (1804-1, 1804-3) is helpful to the user, in that it aids the tab in fitting to the outlet box (1806). The tabs (1804) also compartmentalize the switches (1808, 1810), and guide the electrical power extractors to the appropriate contact location. The tab configuration shown in Figs 18A and 18B can be used with a variety of power extractor configurations and faceplates. For example, the angled and tapered tabs could be used with a single switch faceplate or on an outlet faceplate. Additionally, the tabs may be used in conjunction with coil based power extractors, resilient conductors with conformal insulation or resilient conductors without conformal insulation.

A variety of methods can be used to install an active cover plate over a receptacle. Where an existing cover plate is connected to the outlet, the existing cover plate is removed. The active cover plate is then roughly aligned with the receptacle and the active cover plate is pushed toward the receptacle. In some embodiments, the insulating tabs may be configured to assist in aligning the cover plate with the receptacle as described above. The active cover plate continues to be pushed into place such that resilient conductors are deformed by pressure from terminals of the receptacle. The resilient conductors exert a spring force against the terminals. If electrical contact with the terminals is not satisfactorily achieved to a coating on the terminals such as corrosion or paint, the active cover plate can be repetitively moved toward/away from the receptacle to achieve the desired connection. In some examples, a roughened surface on the power extractors may scrap the corrosion off of the terminals. After the active cover plate is satisfactorily fitted to the receptacle and the desired electrical contact with the receptacle is made, the active cover plate can be secured to the receptacle.

In summary, one embodiment of an active cover plate includes a cover plate for an electrical receptacle. The cover plate includes a first power extractor. The first power extractor protrudes rearward from the cover plate and is configured to contact a first terminal of a receptacle, where the first terminal connects the receptacle to a power source. The power extractor includes a first insulating means, where the first insulating means prevents the first power extractor from electrically contacting other conducting materials. The cover plate further includes a second power extractor. The second power extractor protrudes rearward from the cover plate and is configured to contact a second terminal of the receptacle, where the second terminal completes the connection of the receptacle to the power source. The second power extractor includes a second insulating means, where the second insulating means prevents the second power extractor from electrically contacting other conducting materials. The cover plate also includes a load.

In one implementation, an active cover plate includes a faceplate, a load, and electrically insulated power extractor extending rearward from the faceplate to interface with an electrical receptacle, wherein the power extractor extracts electrical power from the electrical receptacle to energize the load. A faceplate is a portion of an active cover plate that is exposed to view by a user when the active cover plate is fastened over an electrical receptacle. The load is any element or combination of elements that consumes electrical power. A variety of loads are described above, such as light sensors, lights, motion detectors, resistors, diodes, sensors, communication modules, speakers, and other loads. As used in the specification and appended claims, the term "electrically insulated power extractor" refers to mechanisms that extract power from an electrical receptacle. Specifically, "electrically insulated power extractor" refers to:
1) A resilient conductor insulated by a flexible insulating cover that encapsulates the resilient conductor except for exposed portion configured to electrically contact a terminal of an electrical receptacle.
2) A resilient conductor insulated by an insulating tab extending rearward from the faceplate, wherein the insulating tab is interposed between the resilient conductor and an edge of the faceplate. The resilient conductor may or may not include a flexible insulating cover. In some implementations, the insulating tab is a free standing structure separate from the resilient conductor.
3) An encapsulated inductive coil configured to inductively extract power from the electrical receptacle.

In each of the three embodiments of the electrically insulated power extractor, the power extractor includes a free standing, self supporting body. For example, the resilient conductor, the insulating tab, and the encapsulated inductive coil may all be free standing, self supporting bodies. A resilient conductor refers to an electrical resilient conductor that springs back into a predetermined shape after bending or being compressed. When a resilient conductor is physically restrained from returning to its predetermined shape, the resilient conductor exerts a spring force on the restraining object. An electrical terminal is any conductive portion of an electrical receptacle from which power can be extracted or deposited. For example, a hot terminal, a neutral terminal, traveler terminals, and grounds are all electrical terminals. Screws and/or tabs on the side of an electrical receptacle are electrical terminals.

The preceding description has been presented only to illustrate and describe examples of the principles described. This description is not intended to be exhaustive or to limit these principles to any precise form disclosed. Many modifications and variations are possible in light of the above teaching.

## Claims

1. An active cover plate system comprising:
an electrical receptacle (1120, 1220, 1300, 1400) modified to supply power to an active cover plate (1055, 1100, 1200, 1330, 1404, 1430);
the active cover plate comprising:
a faceplate;
a load (1010, 1408, 1410, 1424, 1434); and
an electrically insulated power extractor to interface with the electrical receptacle, wherein the electrically insulated power extractor extracts electrical power from the electrical receptacle to energize the load,
**characterized in that** the electrical receptacle comprises a high voltage coil (1050, 1114, 1204, 1310, 1320, 1402, 1428), wherein the electrically insulated power extractor in the active cover plate comprises a low voltage coil (1020, 1115, 1214, 1338, 1406, 1434), and wherein the high voltage coil and the low voltage coil couple to wirelessly transfer power from the high voltage coil to the low voltage coil, the system further comprising a switching module (1015, 1315, 1336) configured to selectively switch power to the high voltage coil (1050, 1310, 1320) when the active cover plate (1055, 1330) is present or demands power, wherein the power extractor comprises a resilient conductor (910) and an insulating tab (1040, 1132, 1212, 1332) extending rearward from the faceplate, in which the low voltage coil (1020, 1115, 1214, 1338) is encapsulated in the insulating tab.

2. The active cover plate system of claim 1, in which the low voltage coil (1020, 1115, 1214, 1338, 1406, 1434) is configured to inductively extract power from the electrical receptacle (1120, 1220, 1300, 1400), and in which the low voltage coil supplies electrical power to the load (1010, 1408, 1410, 1424, 1434).

3. The active cover plate system of claim 2, in which the high voltage coil (1050, 1114, 1204, 1310, 1320, 1402, 1428) is electrically connected to electrical power supplied by the electrical receptacle (1120, 1220, 1300, 1400).

4. The active cover plate system of claim 3, in which the high voltage coil (1050, 1114, 1204, 1310, 1320, 1402, 1428) is an encapsulated internal component of the electrical receptacle (1120, 1220, 1300, 1400).

5. The active cover plate system according to any of the above claims, wherein the electrical receptacle (1300) comprises at least one switch (1015, 1315, 1336).

6. The active cover plate system according to any of the above claims, wherein the electrical receptacle comprises at least one electrical outlet (1120, 1220, 1300, 1400).

7. The active cover plate system according to any of the above claims, wherein the load comprises lights (1408, 1434) pointing downward from the active cover plate.

8. The active cover plate system according to any of the above claims, wherein the active cover plate (1500, 1505) comprises a touch sensitive control area (1502, 1504, 1508, 1510).

9. The active cover plate system according to any of the above claims, further comprising a wireless module configured to form a wireless network connecting multiple active cover plates.

## Patentansprüche

1. Aktives Abdeckplattensystem mit:
einer Steckdose (1120, 1220, 1300, 1400), die modifiziert ist, um eine aktive Abdeckplatte (1055, 1100, 1200, 1330, 1404, 1430) mit Strom zu versorgen;
wobei die aktive Abdeckplatte versehen ist mit:
einer Blende;
einer Last (1010, 1408, 1410, 1424, 1434), und
einem elektrisch isolierten Stromextraktor, um eine Schnittstelle mit der elektrischen Steckdose zu bilden, wobei der elektrisch isolierte Stromextraktor elektrische Leistung aus der elektrischen Steckdose extrahiert, um die Last mit Strom zu versorgen,
**dadurch gekennzeichnet, dass** die elektrische Steckdose eine Hochspannungsspule (1050, 1114, 1204, 1310, 1320, 1402, 1428) aufweist, wobei der elektrisch isolierte Stromextraktor in der aktiven Abdeckplatte eine Niederspannungsspule (1020, 1115, 1214, 1338, 1406, 1434) aufweist, und wobei die Hochspannungsspule und die Niederspannungsspule gekoppelt sind, um drahtlos Energie von der Hochspannungsspule auf die Niederspannungsspule zu übertragen, wobei das System ferner ein Umschaltmodul (1015, 1315, 1336) aufweist, welches ausgebildet ist, um selektiv Leistung auf die Hochspannungsspule (1050, 1310, 1320) zu schalten, wenn die aktive Abdeckplatte (1055, 1330) vorhanden ist oder Leistung verlangt, wobei der Stromextraktor einen nachgiebigen Leiter (910) und eine isolierende Öse (1040, 1132, 1212, 1332) aufweist, die sich nach hinten von der Blende erstreckt, wobei die Niederspannungsspule (1020, 1115, 1214, 1338) in der isolierenden Öse verkapselt ist.

2. Aktives Abdeckplattensystem gemäß Anspruch 1, wobei die Niederspannungsspule (1020, 1115, 1214, 1338, 1406, 1434) ausgebildet ist, um Leistung induktiv aus der elektrischen Steckdose (1120, 1220, 1300, 1400) zu extrahieren, und wobei die Niederspannungsspule die Last (1010, 1408, 1410, 1424, 1434) mit Strom versorgt.

3. Aktives Abdeckplattensystem gemäß Anspruch 2, wobei die Hochspannungsspule (1050, 1114, 1204, 1310, 1320, 1402, 1428) elektrisch mit elektrischer Energie verbunden ist, die von der elektrischen Steckdose (1120, 1220, 1300, 1400) zugeführt wird.

4. Aktives Abdeckplattensystem gemäß Anspruch 3, wobei die Hochspannungsspule (1050, 1114, 1204, 1310, 1320, 1402, 1428) eine gekapselte interne Komponente der elektrischen Steckdose (1120, 1220, 1300, 1400) ist.

5. Aktives Abdeckplattensystem gemäß einem der vorhergehenden Ansprüche, wobei die elektrische Steckdose (1300) mindestens einen Schalter (1015, 1315, 1336) aufweist.

6. Aktives Abdeckplattensystem gemäß einem der vorhergehenden Ansprüche, wobei die elektrische Steckdose mindestens einen elektrischen Auslass (1120, 1220, 1300, 1400) aufweist.

7. Aktives Abdeckplattensystem gemäß einem der vorhergehenden Ansprüche, wobei die Last Leuchten (1408, 1434) aufweist, die von der aktiven Abdeckplatte nach unten weisen.

8. Aktives Abdeckplattensystem gemäß einem der vorhergehenden Ansprüche, wobei die aktive Abdeckplatte (1500, 1505) einen berührungsempfindlichen Steuerbereich (1502, 1504, 1508, 1510) aufweist.

9. Aktives Abdeckplattensystem gemäß einem der vorhergehenden Ansprüche, ferner versehen mit einem drahtlosen Modul, welches ausgebildet ist, um ein drahtloses Netzwerk zu bilden, welches mehrere aktive Abdeckplatten verbindet.

## Revendications

1. Système à plaque de recouvrement active comprenant :
un réceptacle électrique (1120, 1220, 1300, 1400) modifié pour alimenter une plaque de recouvrement active (1055, 1100, 1200, 1330, 1404, 1430) ;
la plaque de recouvrement active comprenant :
une plaque frontale ;
une charge (1010, 1408, 1410, 1424, 1434) ; et
un extracteur de puissance isolé électriquement pour s'interfacer avec le réceptacle électrique, dans lequel l'extracteur de puissance isolé électriquement extrait l'énergie électrique du réceptacle électrique pour alimenter la charge,
**caractérisé en ce que** le réceptacle électrique comprend une bobine à haute tension (1050, 1114, 1204, 1310, 1320, 1402, 1428), dans lequel l'extracteur de puissance isolé électriquement dans la plaque de recouvrement active comprend une bobine à basse tension (1020, 1115, 1214, 1338, 1406, 1434), et dans lequel la bobine à haute tension et la bobine à basse tension s'unissent pour transférer sans fil l'alimentation de la bobine à haute tension à la bobine à basse tension, le système comprenant en outre un module de commutation (1015, 1315, 1336) configuré pour commuter sélectivement l'alimentation de la bobine à haute tension (1050, 1310, 1320) lorsque la plaque de recouvrement active (1055, 1330) est présente ou demande de la puissance, dans lequel l'extracteur de puissance comprend un conducteur élastique (910) et une languette isolante (1040, 1132, 1212, 1332) s'étendant vers l'arrière depuis la plaque frontale, dans laquelle la bobine à basse tension encapsulée (1020, 1115, 1214, 1338) est encapsulée dans languette isolante.

2. Système à plaque de recouvrement active selon la revendication 1, dans lequel la bobine à basse tension (1020, 1115, 1214, 1338, 1406, 1434) est configurée pour extraire par induction l'énergie du réceptacle électrique (1120, 1220, 1300, 1400) et dans lequel la bobine à basse tension encapsulée fournit de l'énergie électrique à la charge (1010, 1408, 1410, 1424, 1434).

3. Système à plaque de recouvrement active selon la revendication 2, dans lequel la bobine à haute tension (1050, 1114, 1204, 1310, 1320, 1402, 1428) est connectée électriquement à l'alimentation électrique fournie par le réceptacle électrique (1120, 1220, 1300, 1400).

4. Système à plaque de recouvrement active selon la revendication 3, dans lequel la bobine à haute tension (1050, 1114, 1204, 1310, 1320, 1402, 1428) est un composant interne encapsulé du réceptacle électrique (1120, 1220, 1300, 1400).

5. Système à plaque de recouvrement active selon une quelconque des revendications ci-dessus, dans lequel le réceptacle électrique (1300) comprend au moins un commutateur (1015, 1315, 1336).

6. Système à plaque de recouvrement active selon une quelconque des revendications ci-dessus, dans lequel le réceptacle électrique (1300) comprend au moins une sortie électrique (1120, 1220, 1300, 1400).

7. Système à plaque de recouvrement active selon une quelconque des revendications ci-dessus, dans lequel la charge comprend des lumières (1408, 1434) dirigées vers le bas à partir de la plaque de recouvrement active.

8. Système à plaque de recouvrement active selon une quelconque des revendications ci-dessus, dans lequel la plaque de couverture active (1500, 1505) comprend une zone de commande sensible au toucher (1502, 1504, 1508, 1510).

9. Système à plaque de recouvrement active selon une quelconque des revendications ci-dessus, comprenant en outre un module sans fil configuré pour former un réseau sans fil connectant plusieurs plaques de recouvrement actives.
